(19) Europäisches Patentamt
European Patent Office
Office européen des brevets

(11) EP 4 332 123 A1

(12) EUROPEAN PATENT APPLICATION
published in accordance with Art. 153(4) EPC

(43) Date of publication:
**06.03.2024 Bulletin 2024/10**

(21) Application number: **22795250.4**

(22) Date of filing: **21.02.2022**

(51) International Patent Classification (IPC):
***C08F 2/44*** (2006.01) ***C08F 2/50*** (2006.01)
***G03F 7/004*** (2006.01) ***G03F 7/027*** (2006.01)

(52) Cooperative Patent Classification (CPC):
**C08F 2/44; C08F 2/50; G02B 5/02; G03F 7/004; G03F 7/027**

(86) International application number:
**PCT/JP2022/007016**

(87) International publication number:
**WO 2022/230327 (03.11.2022 Gazette 2022/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.04.2021 JP 2021075827**

(71) Applicant: **Sumitomo Chemical Company Limited
Tokyo 103-6020 (JP)**

(72) Inventors:
- **TOKUDA, Masayoshi
Osaka-shi, Osaka 554-8558 (JP)**
- **HARADA, Yoshihiro
Osaka-shi, Osaka 554-8558 (JP)**
- **KOMATSU, Yoshifumi
Osaka-shi, Osaka 554-8558 (JP)**
- **NISHIOKA, Koji
Osaka-shi, Osaka 554-8558 (JP)**

(74) Representative: **Vossius & Partner
Patentanwälte Rechtsanwälte mbB
Siebertstrasse 3
81675 München (DE)**

# (54) CURED FILM AND DISPLAY DEVICE

(57) Provided is a cured film of a curable composition containing a light scattering agent that is strongly resistant to deformation and breakdown and a method enabling the production of the cured film.

Provided is a cured film of a curable composition containing a light scattering agent (A) and a photopolymerizable compound (B), in which the cured film has a Martens hardness of 0.10 GPa or more, and a method for producing a cured film of a curable composition containing a light scattering agent (A) and a photopolymerizable compound (B), the method including an exposure step of irradiating a film of the curable composition with light and a thermal curing step of thermally curing the film of the curable composition, in which, when a light exposure in the exposure step is indicated by X ($mJ/cm^2$), a thermal curing temperature in the thermal curing step is indicated by Y (°C), and a thermal curing time is indicated by Z (hr), a formula (1): $X \times Y \times Z^2 \geq 3000$ is satisfied.

EP 4 332 123 A1

## Description

Technical Field

The present invention relates to a cured film and a display device including the cured film.

Background Art

Patent Literature 1 discloses a photosensitive resin composition that is used to form a red, green, blue, or other color pattern or a white (transparent) pattern and a cured film and a color filter that are formed from the composition.

Citation List

Patent Literature

Patent Literature 1: International Publication No. 2014/157296

Summary of Invention

Technical Problem

The white (transparent) pattern usually does not contain any colorants enabling light with a wavelength that has been incident thereon to outgo with a desired wavelength (for example, red, green, or the like), but contains a light scattering agent to scatter and transmit the incident light.

An object of the present invention is to provide a cured film of a curable composition containing a light scattering agent that is strongly resistant to deformation and breakdown and a method enabling the production of the cured film. Another object of the present invention is to provide a display device including the cured film.

Solution to Problem

The present invention provides a cured film, a method for producing a cured film, and a display device shown below.

[1] A cured film of a curable composition, the curable composition comprising a light scattering agent (A) and a photopolymerizable compound (B),
wherein the cured film has a Martens hardness of 0.10 GPa or more.
[2] The cured film according to [1], wherein the curable composition further comprises a photopolymerization initiator (C).
[3] The cured film according to [1] or [2], wherein the curable composition further comprises a resin (D).
[4] The cured film according to any one of [1] to [3], wherein the light scattering agent (A) contains $TiO_2$ particles.
[5] A method for producing a cured film of a curable composition comprising a light scattering agent (A) and a photopolymerizable compound (B), the method comprising:

an exposure step of irradiating a film of the curable composition with light; and
a thermal curing step of thermally curing the film of the curable composition,
wherein, when a light exposure in the exposure step is indicated by X ($mJ/cm^2$), a thermal curing temperature in the thermal curing step is indicated by Y (°C), and a thermal curing time is indicated by Z (hr), the following formula (1):

$$X \times Y \times Z^2 \geq 3000 \quad (1)$$

is satisfied.

[6] The production method according to [5], wherein the thermal curing step is carried out under a vacuum atmosphere.
[7] A display device comprising the cured film according to any one of [1] to [4].

Advantageous Effects of Invention

It is possible to provide a cured film of a curable composition containing a light scattering agent that is strongly resistant to deformation and breakdown, a method enabling the production of the cured film, and a display device including the cured film.

Description of Embodiments

«Cured film»

A cured film according to the present invention (hereinafter, also simply referred to as "cured film") is a cured film of a curable composition and can be formed by curing the curable composition. The curable composition contains at least a light scattering agent (A) and a photopolymerizable compound (B).

The cured film according to the present invention can become a white (transparent or achromatic) cured film, for example a cured pattern, and does not contain any colorants (quantum dots, a pigment, a dye, or the like) enabling the outgoing of light with a chromatic color such as red or green when light from a light source (for example, a blue light source) has been incident. That is, the cured film according to the present invention usually causes light having the same or almost the same wavelength as that of incident light to outgo while being scattered.

As used herein, the cured pattern is one embodiment of the cured film, and refers to a cured film formed in a pattern.

For the cured film, the Martens hardness that is measured by a method described in examples described later is 0.10 GPa or more. The Martens hardness of the cured film is preferably 0.12 GPa or more, more preferably 0.15 GPa or more, still more preferably 0.20 GPa or more, yet still more preferably 0.23 GPa or more, and particularly preferably 0.24 GPa or more. The Martens hardness is hardness containing both components of the plastic deformation and elastic deformation of the cured film and is a characteristic value including not only the hardness or deformation difficulty of the cured film but also the flexibility. According to a cured film having a Martens hardness of 0.10 GPa or more, it is possible to increase the deformation resistance and breakdown resistance of the cured film. When the cured film is used as the white (transparent) pattern, it is possible to prevent the deformation or breakdown of the film during the production or use of a device including the film.

The cured film may also have high wear resistance. The wear resistance of the cured film can be evaluated with pencil hardness, and, specifically, the pencil hardness that is measured by a method described in the examples described later is preferably B or more, more preferably H or more, still more preferably 2H or more, yet still more preferably 3H or more and particularly preferably 4H or more. According to a cured film having a pencil hardness of 2B or more, generation of a scratch on the surface of the cured film in a process for producing a display device is less likely, and it is possible to suppress a decrease in the outgoing light intensity or the deterioration of the cured film during long-term use caused by the scratch on the surface.

According to the present invention, it is also possible to provide a cured film having a pencil hardness of B or more and having a high outgoing light intensity.

The Martens hardness of the cured film is preferably 0.35 GPa or less, more preferably 0.32 GPa or less, still more preferably 0.30 GPa or less, yet still more preferably less than 0.30 GPa, and particularly preferably 0.28 GPa or less and may be 0.26 GPa or less and, furthermore, may be 0.25 GPa or less. When the Martens hardness of the cured film is excessively large, the outgoing light intensity may decrease when the cured film is used as a white (transparent) pattern. A decrease in the outgoing light intensity is considered to arise from, for example, the fact that the shrinkage of the cured film causes the light scattering agent (A) in the cured film to agglomerate and come close to each other, which makes light scattered in the cured film and decreases the light extraction efficiency.

The outgoing light intensity when light has been made incident on the cured film can be evaluated with an optical density (OD value) that is measured by a method described in the examples described later. Since the OD value also depends on the film thickness T of the cured film, in the present specification, a value (OD value/T) obtained by dividing the OD value by the film thickness T (unit: μm) was used as an index of the outgoing light intensity. As the OD value/T becomes smaller, the outgoing light intensity becomes larger. On the other hand, when the OD value/T is set to be large, it is possible to improve the viewing angle characteristics of the cure film.

The OD value/T of the cured film is preferably 0.0400 or less, more preferably 0.0350 or less, still more preferably 0.0200 or less, yet still more preferably 0.0190 or less, yet still more preferably 0.0180 or less, yet still more preferably 0.0170 or less, particularly preferably 0.0160 or less, and more particularly preferably less than 0.0145. The OD value/T may be 0.0050 or more, 0.0100 or more, 0.0130 or more, 0.0140 or more, or 0.0146 or more. When the OD value/T is within the above range, it becomes easy to adjust the color balance in the case where pixels are constituted of a combination of a pattern made of the cured film and a chromatic pattern.

In one preferable embodiment, the cured film has a Martens hardness of 0.10 GPa or more and an OD value/T

of 0.020 or less. In another preferable embodiment, the cured film has a Martens hardness of 0.15 GPa or more and an OD value/T of 0.020 or less. In still another preferable embodiment, the cured film has a Martens hardness of 0.10 GPa or more, a pencil hardness of B or more, and an OD value/T of 0.020 or less. In these embodiments, the OD value/T is preferably 0.019 or less, more preferably 0.018 or less, still more preferably 0.017 or less, and yet still more preferably 0.016 or less.

In addition, a value obtained by dividing the OD value/T of the cured film by the content ratio of the light scattering agent (A) in the curable composition (based on the total amount of the solid content of the curable composition) is preferably 0.00450 or less, more preferably 0.00400 or less, still more preferably 0.00360 or less, yet still more preferably 0.00350 or less, yet still more preferably 0.00300 or less, particularly preferably 0.00285 or less and preferably 0.00100 or more, more preferably 0.00200 or more, and still more preferably 0.00250 or more. When the above value is within the above range, it becomes easy to adjust the color balance in the case where pixels are constituted of a combination of a pattern made of the cured film and a chromatic pattern.

The cured film according to the present invention is not particularly limited, but can be preferably produced by a method described in <<method for producing cured film>> described later.

<Curable composition>

The curable composition contains a light scattering agent (A) and a photopolymerizable compound (B).

[1] Light scattering agent (A)

The cured film formed from the curable composition containing the light scattering agent (A) is capable of causing light having the same or almost the same wavelength as that of light that is incident on the cured film to outgo while being scattered. In addition, when the light scattering agent (A) is contained in the cured film, it is possible to control the light transmittance or viewing angle characteristics of the cure film or to improve the outgoing light intensity of the cured film.

Examples of the light scattering agent (A) include particles of metal or metal oxide and inorganic particles such as glass particles, and particles of metal oxide are preferable since the particles of metal oxide do not absorb light by coloration and have only a scattering effect. Examples of the metal oxide include TiOz, $SiO_2$, BaTiOs, ZnO and the like, and $TiO_2$ particles are preferable since TiOz particles efficiently scatter light. Generally, the inorganic particles hardly disperse in solvents as they are, and thus, usually, a dispersant described later is used. The light scattering agent (A) may contain two or more kinds of particles.

The particle size of the light scattering agent (A) is, for example, 0.03 μm or more and 20 μm or less, and from the viewpoint of increasing the light scattering capability and increasing the dispersibility in the curable composition, preferably 0.05 μm or more and 1 μm or less, and more preferably 0.05 μm or more and 0.5 μm or less.

As the light scattering agent (A), a light scattering agent previously dispersed in a part or the whole of a solvent (G) using a dispersant may be used. Commercially available products may also be used as the dispersant.

Examples of such commercial products include: DISPERBYK-101, 102, 103, 106, 107, 108, 109, 110, 111, 116, 118, 130, 140, 154, 161, 162, 163, 164, 165, 166, 170, 171, 174, 180, 181, 182, 183, 184, 185, 190, 192, 2000, 2001, 2020, 2025, 2050, 2070, 2095, 2150, 2155; ANTI-TERRA-U, U100, 203, 204, 250, ; BYK-P104, P104S, P105, 220S, 6919; BYK-LPN6919, and 21116; LACTIMON and LACTIMON-WS; Bykumen; and the like, manufactured by BYK Japan KK;

SOLSPERSE-3000, 9000, 13000, 13240, 13650, 13940, 16000, 17000, 18000, 20000, 21000, 24000, 26000, 27000, 28000, 31845, 32000, 32500, 32550, 33500, 32600, 34750, 35100, 36600, 38500, 41000, 41090, 53095, 55000, 76500, and the like, manufactured by Lubrizol Japan Limited;
EFKA-46, 47, 48, 452, 4008, 4009, 4010, 4015, 4020, 4047, 4050, 4055, 4060, 4080, 4400, 4401, 4402, 4403, 4406, 4408, 4300, 4310, 4320, 4330, 4340, 450, 451, 453, 4540, 4550, 4560, 4800, 5010, 5065, 5066, 5070, 7500, 7554, 1101, 120, 150, 1501, 1502, 1503, and the like, manufactured by BASF Japan Ltd.; and
AJISPER PA111, PB711, PB821, PB822, and PB824, manufactured by Ajinomoto Fine-Techno Co., Inc.

The content ratio of the light scattering agent (A) in the curable composition is, for example, based on the total solid content of the curable composition, 0.001% by mass or more and 50% by mass or less, and from the viewpoint of the developability of the cured film, the viewpoint of increasing the light scattering capability, and the viewpoint of improving the outgoing light intensity of the cured film, preferably 1% by mass or more and 30% by mass or less, more preferably 2% by mass or more and 10% by mass or less, and still more preferably 3% by mass or more and 8% by mass or less.

As used herein, the total amount of solid content means the total of the components contained in the curable

composition, excluding a solvent (G). The content ratio of each component in the solid content of the curable composition can be measured by a known analytical means such as liquid chromatography or gas chromatography. The content ratio of each component in the solid content of the curable composition may be calculated from formulation at the time of preparing the curable composition.

[2] Photopolymerizable compound (B)

The curable composition contains one or more photopolymerizable compounds (B). The photopolymerizable compound (B) is a compound that can be polymerized with an active radical, acid or the like generated from a photopolymerization initiator (C) described later. Examples of the photopolymerizable compound (B) include a photo-radical polymerizable compound that cures by a radical polymerization reaction when irradiated with light, and a photo cationic polymerizable compound that cures by a cationic polymerization reaction when irradiated with light. The photopolymerizable compound (B) is preferably a photo-radical polymerizable compound.

The weight-average molecular weight of the photopolymerizable compound (B) is, for example, 150 or more and 3000 or less, preferably 150 or more and 2900 or less, and more preferably 250 or more and 1500 or less.

Examples of the photo-radical polymerizable compound include compounds having a polymerizable ethylenically unsaturated bond, and, among them, (meth)acrylate compounds are preferable. Examples of the (meth)acrylate compounds include monofunctional (meth)acrylate monomers having one (meth)acryloyloxy group in the molecule (hereinafter, also referred to as "compound (B-1)"), difunctional (meth)acrylate monomers having two (meth)acryloyloxy groups in the molecule (hereinafter, also referred to as "compound (B-2)"), and polyfunctional (meth)acrylate monomers having three or more (meth)acryloyloxy groups in the molecule (hereinafter, also referred to as "compound (B-3)").

As used herein, "(meth)acrylate" means an acrylate and/or a methacrylate. The same applies to "(meth)acryloyl", "(meth)acrylic acid", and the like.

Examples of the compound (B-1) include methyl (meth)acrylate, ethyl (meth)acrylate, propyl (meth)acrylate, butyl (meth)acrylate, amyl (meth)acrylate, hexyl (meth)acrylate, 2-ethylhexyl (meth)acrylate, octyl (meth)acrylate, nonyl (meth)acrylate, dodecyl (meth)acrylate (lauryl (meth)acrylate), hexadecyl (meth)acrylate, octadecyl (meth)acrylate, cyclohexyl (meth)acrylate, methoxyethyl (meth)acrylate, butoxyethyl (meth)acrylate, phenoxyethyl (meth)acrylate, nonylphenoxyethyl (meth)acrylate, glycidyl (meth)acrylate, dimethylaminoethyl (meth)acrylate, diethylaminoethyl (meth)acrylate, isobornyl (meth)acrylate, dicyclopentanyl (meth)acrylate, dicyclopentenyl (meth)acrylate, dicyclopentenyloxyethyl (meth)acrylate, 2-hydroxy-3-phenoxypropyl (meth)acrylate, tetrahydrofurfuryl (meth)acrylate, 2-hydroxyethyl (meth)acrylate, benzyl (meth)acrylate, phenyl (meth)acrylate, mono(2-acryloyloxyethyl) succinate, N-[2-(acryloyloxy)ethyl]phthalimide, N-[2-(acryloyloxy)ethyl]tetrahydrophthalimide, 2-(2-vinyloxyethoxy)ethyl (meth)acrylate, ω-carboxy-polycaprolactone monoacrylate, ethyl carbitol (meth)acrylate (ethoxyethoxyethyl (meth)acrylate), and 3,3,5-trimethylcyclohexyl (meth)acrylate.

Examples of the compound (B-2) include 1,3-butylene glycol di(meth)acrylate, 1,4-butanediol di(meth)acrylate, 1,5-pentanediol di(meth)acrylate, 3-methyl-1,5-pentanediol di(meth)acrylate, 1,6-hexanediol di(meth)acrylate, neopentyl glycol di(meth)acrylate, 1,8-octanediol di(meth)acrylate, 1,9-nonanediol di(meth)acrylate, tricyclodecanedimethanol di(meth)acrylate, ethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, neopentyl glycol hydroxypivalic acid ester di(meth)acrylate, di(meth)acrylate in which two hydroxyl groups of tris(2-hydroxyethyl) isocyanurate are replaced by (meth)acryloyloxy groups, di(meth)acrylate in which two hydroxyl groups of a diol obtained by adding 4 mol or more of ethylene oxide or propylene oxide to 1 mol of neopentyl glycol are replaced by (meth)acryloyloxy groups, di(meth)acrylate in which two hydroxyl groups of a diol obtained by adding 2 mol of ethylene oxide or propylene oxide to 1 mol of bisphenol A are replaced by (meth)acryloyloxy groups, di(meth)acrylate in which two hydroxyl groups of a triol obtained by adding 3 mol or more of ethylene oxide or propylene oxide to 1 mol of trimethylolpropane are replaced by (meth)acryloyloxy groups, and di(meth)acrylate in which two hydroxyl groups of a diol obtained by adding 4 mol or more of ethylene oxide or propylene oxide to 1 mol of bisphenol A are replaced by (meth)acryloyloxy groups.

Examples of the compound (B-3) include glycerin tri(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, caprolactone-modified dipentaerythritol hexa(meth)acrylate, pentaerythritol triacrylate succinic acid monoester, dipentaerythritol pentaacrylate succinic acid monoester, pentaerythritol triacrylate maleic acid monoester, and dipentaerythritol pentaacrylate maleic acid monoester.

Examples of the photo cationic polymerizable compound include compounds having at least one oxetane ring

(4-membered ring ether) in the molecule (hereinafter, also simply referred to as "oxetane compounds"), compounds having at least one oxirane ring (3-membered ring ether) in the molecule (hereinafter, also simply referred to as "epoxy compounds"), and vinyl ether compounds.

Examples of the oxetane compounds include 3-ethyl-3-hydroxymethyloxetane, 1,4-bis[(3-ethyl-3-oxetanyl)methoxymethyl]benzene, 3-ethyl-3-(phenoxymethyl)oxetane, di[(3-ethyl-3-oxetanyl)methyl]ether, 3-ethyl-3-(2-ethylhexyloxymethyl)oxetane, and phenol novolac oxetane. As these oxetane compounds, commercially available products can be easily procured, and examples of the commercially available products include "ARON OXETANE (registered trademark) OXT-101", "ARON OXETANE (registered trademark) OXT-121", "ARON OXETANE (registered trademark) OXT-211", "ARON OXETANE (registered trademark) OXT-221", and "ARON OXETANE (registered trademark) OXT-212", all of which are trade names that have been put on sale by Toagosei Co., Ltd.

Examples of the epoxy compounds include aromatic epoxy compounds, glycidyl ethers of a polyol having an alicyclic ring, aliphatic epoxy compounds, and alicyclic epoxy compounds.

Examples of the aromatic epoxy compounds include bisphenol type epoxy resins such as a diglycidyl ether of bisphenol A, a diglycidyl ether of bisphenol F and a diglycidyl ether of bisphenol S; novolac type epoxy resins such as a phenol novolac epoxy resin, a cresol novolak epoxy resin and a hydroxybenzaldehyde phenol novolac epoxy resin; and polyfunctional epoxy resins such as a glycidyl ether of tetrahydroxyphenylmethane, a glycidyl ether of tetrahydroxybenzophenone, and epoxidized polyvinylphenol.

Examples of the glycidyl ethers of a polyol having an alicyclic ring include glycidyl etherified products of a nuclear hydrogenated polyhydroxy compound that is obtained by selectively hydrogenating the aromatic ring of an aromatic polyol in the presence of a catalyst under pressure. Examples of the aromatic polyol include bisphenol type compounds such as bisphenol A, bisphenol F, and bisphenol S; novolac type resins such as a phenol novolac resin, a cresol novolac resin, and a hydroxybenzaldehyde phenol novolac resin; and polyfunctional compounds such as tetrahydroxydiphenylmethane, tetrahydroxybenzophenone, and polyvinylphenol. Glycidyl ethers can be produced by reacting epichlorohydrin with an alicyclic polyol that is obtained by hydrogenating the aromatic ring of the aromatic polyol. Among these glycidyl ethers of a polyol having an alicyclic ring, diglycidyl ethers of hydrogenated bisphenol A are preferable.

Examples of the aliphatic epoxy compounds include polyglycidyl ethers of an aliphatic polyhydric alcohol or an alkylene oxide adduct thereof. Specific examples thereof include diglycidyl ethers of 1,4-butanediol; diglycidyl ethers of 1,6-hexanediol; triglycidyl ethers of glycerin; triglycidyl ethers of trimethylolpropane; diglycidyl ethers of polyethylene glycol; diglycidyl ethers of propylene glycol; diglycidyl ethers of neopentyl glycol; and polyglycidyl ethers of a polyether polyol that are obtained by adding one or more alkylene oxides (ethylene oxide or propylene oxide) to an aliphatic polyhydric alcohol such as ethylene glycol, propylene glycol or glycerin.

The alicyclic epoxy compounds are compounds having at least one structure that forms an oxirane ring together with a carbon atom in an alicyclic ring in the molecule, and "CELLOXIDE" series and "CYCLOMER" (all manufactured by Daicel Corporation), "CYRACURE UVR" series (manufactured by Dow Inc.), and the like can be used.

Examples of the vinyl ether compounds include 2-hydroxyethyl vinyl ether, triethylene glycol vinyl monoether, tetraethylene glycol divinyl ether, and trimethylolpropane trivinyl ether.

The photopolymerizable compound (B) preferably contains a polyfunctional (meth)acrylate monomer having three or more (meth)acryloyloxy groups in the molecule (compound (B-3)). When the curable composition contains the compound (B-3), it is possible to increase the heat resistance and mechanical strengths of the curable composition and the cured film, and, furthermore, containing the compound (B-3) may be advantageous in improving the outgoing light intensity of the cured film. In addition, when the curable composition contains the compound (B-3), it is possible to improve the curing property of the curable composition.

Examples of the compound (B-3) include a compound (B-3a) having three or more (meth)acryloyloxy groups and having an acidic functional group in the molecule and a compound (B-3b) having three or more (meth)acryloyloxy groups but having no acidic functional groups in the molecule. The photopolymerizable compound (B) preferably contains at least one of the compound (B-3a) and the compound (B-3b) and may contain two or more compounds (B-3a), two or more compounds (B-3b) or at least one compound (B-3a) and at least one compound (B-3b).

The curable composition preferably contains the compound (B-3a) as the photopolymerizable compound. When the curable composition contains the compound (B-3a), the dispersibility of the light scattering agent (A) in the curable composition can be improved, whereby the outgoing light intensity of the cured film can be improved. In addition, when the curable composition contains the compound (B-3a), it is possible to improve the curing property of the curable composition. Furthermore, when the curable composition contains the compound (B-3a), it is possible to improve the heat resistance of the curable composition and the cured film.

In one embodiment, from the viewpoint of increasing the development speed of the curable composition, the photopolymerizable compound (B) contains 50% by mass or more of the compound (B-3b) based on the total amount of the photopolymerizable compound (B) that is contained in the curable composition. In another embodiment, from the viewpoint of improving the solvent resistance (residual film ratio) of the cured film, the photopolymerizable compound (B) contains the compound (B-3a) and the compound (B-3b).

Examples of the acidic functional group include a carboxy group, a sulfonic acid group, and a phosphate group. Among these, the acidic functional group is preferably a carboxy group.

The number of the (meth)acryloyloxy groups contained in one molecule of the compound (B-3) is, for example, 3 or more and 6 or less, preferably 3 or more and 5 or less, and more preferably 3. The number of the acidic functional groups contained in one molecule of the compound (B-3a) is 1 or more and preferably 1. In the case where the compound (B-3a) has two or more acidic functional groups, the individual acidic functional groups may be different from or the same as each other, and the compound (B-3a) preferably has at least one carboxy group.

Examples of the compound (B-3a) include compounds obtained by esterifying a compound having three or more (meth)acryloyloxy groups and a hydroxy group, such as pentaerythritol tri(meth)acrylate or dipentaerythritol penta(meth)acrylate, and a dicarboxylic acid. Examples of the compound include a compound obtained by monoesterifying pentaerythritol tri(meth)acrylate and succinic acid, a compound obtained by monoesterifying dipentaerythritol penta(meth)acrylate and succinic acid, a compound obtained by monoesterifying pentaerythritol tri(meth)acrylate and maleic acid, and a compound obtained by monoesterifying dipentaerythritol penta(meth)acrylate and maleic acid. Of these, a compound obtained by monoesterifying pentaerythritol tri(meth)acrylate and succinic acid is preferable.

Examples of the commercially available product of the compound (B-3a) include "ARONIX M-510" manufactured by Toagosei Co., Ltd. containing a dibasic acid anhydride adduct of pentaerythritol tri(meth)acrylate as a main component, "ARONIX M-520D" manufactured by Toagosei Co., Ltd. containing a dibasic acid anhydride adduct of dipentaerythritol penta(meth)acrylate as a main component. These commercially available products have a carboxy group as the acidic functional group.

In the case where the photopolymerizable compound (B) contains the compound (B-3) (preferably the compound (B-3a)), the content ratio of the compound (B-3) is preferably 5% by mass or more, more preferably 10% by mass or more, still more preferably 20% by mass or more and preferably 70% by mass or less, more preferably 60% by mass or less, still more preferably 50% by mass or less and yet still more preferably 40% by mass or less, and particularly preferably 30% by mass or less, based on the total amount of the photopolymerizable compound (B), from the viewpoint of increasing the curing property of the curable composition, the heat resistance and outgoing light intensity of the cured film, and the like.

In the case where the photopolymerizable compound (B) contains the compound (B-3) (preferably the compound (B-3a)), the content ratio of the compound (B-3) is preferably 0.1% by mass or more and 50% by mass or less, more preferably 1% by mass or more and 40% by mass or less, still more preferably 2% by mass or more and 30% by mass or less, yet still more preferably 5% by mass or more and 20% by mass or less, and particularly preferably 5% by mass or more and 15% by mass or less, based on the total amount of the curable composition or the total amount of the solid content of the curable composition, from the viewpoint of increasing the curing property of the curable composition, the heat resistance and outgoing light intensity of the cured film, and the like.

The photopolymerizable compound (B) preferably contains a (meth)acrylate monomer (hereinafter, also referred to as "compound (B-4)") having a vinyl ether group and a (meth)acryloyl group (preferably a (meth)acryloyloxy group) in the same molecule. When the curable composition contains the compound (B-4), the dispersibility of the light scattering agent (A) in the curable composition can be improved, whereby the outgoing light intensity of the cured film can be improved. In addition, when the curable composition contains the compound (B-4), it is possible to reduce the viscosity of the curable composition and to improve the applicability. The compound (B-4) can be a compound belonging to any of the compound (B-1) to the compound (B-3).

The number of the vinyl ether groups contained in the compound (B-4) is preferably 1 or more and 4 or less, more preferably 1 or more and 2 or less, and particularly preferably 1. The number of the (meth)acryloyl groups contained in the compound (B-4) is preferably 1 or more and 4 or less, more preferably 1 or more and 2 or less, and particularly preferably 1.

Examples of the compound (B-4) include 2-vinyloxyethyl (meth)acrylate, 3-vinyloxypropyl (meth)acrylate, 2-vinyloxypropyl (meth)acrylate, 1-vinyloxypropyl (meth)acrylate, 1-methyl-2-vinyloxyethyl (meth)acrylate, 4-vinyloxybutyl (meth)acrylate, 3-vinyloxybutyl (meth)acrylate, 2-vinyloxybutyl (meth)acrylate, 1-methyl-3-vinyloxypropyl (meth)acrylate, 2-methyl-3-vinyloxypropyl (meth)acrylate, 1-methyl-2-vinyloxypropyl (meth)acrylate, 1,1-dimethyl-2-vinyloxyethyl (meth)acrylate, 6-vinyloxyhexyl (meth)acrylate, 4-vinyloxycyclohexyl (meth)acrylate, (4-vinyloxymethylcyclohexyl)methyl (meth)acrylate, (3-vinyloxymethylcyclohexyl)methyl (meth)acrylate, (2-vinyloxymethylcyclohexyl)methyl (meth)acrylate, (4-vinyloxymethylphenyl)methyl (meth)acrylate, (3-vinyloxymethylphenyl)methyl (meth)acrylate, 2-vinyloxymethylphenylmethyl (meth)acrylate, 2-(2-vinyloxyisopropoxy)ethyl (meth)acrylate, 2-(2-vinyloxyethoxy)ethyl (meth)acrylate, 2-(2-vinyloxyethoxy)propyl (meth)acrylate, 2-(2-vinyloxyisopropoxy)propyl (meth)acrylate, 2-(2-vinyloxyethoxy)isopropyl (meth)acrylate, 2-(2-vinyloxyisopropoxy)isopropyl (meth)acrylate, 2-{2-(2-vinyloxyethoxy)ethoxy}ethyl (meth)acrylate, 2-{2-(2-vinyloxyisopropoxy)ethoxy}ethyl (meth)acrylate, 2-{2-(2-vinyloxyisopropoxy)isopropoxy}ethyl (meth)acrylate, 2-{2-(2-vinyloxyethoxy)ethoxy}propyl (meth)acrylate, 2-{2-(2-vinyloxyethoxy)isopropoxy}propyl (meth)acrylate, 2-{2-(2-vinyloxyisopropoxy)ethoxy}propyl (meth)acrylate, 2-{2-(2-vinyloxyisopropoxy)isopropoxy}propyl (meth)acrylate, 2-{2-(2-vinyloxyethoxy)ethoxy}isopropyl (meth)acrylate, 2-{2-(2-vinyloxyethoxy)isopropoxy}isopropyl (meth)acrylate,

2-{2-(2-vinyloxyisopropoxy)ethoxy}isopropyl (meth)acrylate, 2-{2-(2-vinyloxyisopropoxy)isopropoxy}isopropyl (meth)acrylate, 2-[2-{2-(2-vinyloxyethoxy)ethoxy}ethoxy]ethyl (meth)acrylate, 2-[2-{2-(2-vinyloxyisopropoxy)ethoxy}ethoxy]ethyl (meth)acrylate, and 2-(2-[2-{2-(2-vinyloxyethoxy)ethoxy}ethoxy]ethoxy)ethyl (meth)acrylate.

The compound (B-4) is preferably vinyloxy $C_{1-6}$ alkyl (meth) acrylate or (vinyloxy $C_{1-4}$ alkoxy) $C_{1-4}$ alkyl (meth) acrylate, more preferably (vinyloxy $C_{1-4}$ alkoxy) $C_{1-4}$ alkyl (meth)acrylate, and particularly preferably 2-(2-vinyloxyethoxy)ethyl (meth)acrylate.

In the case where the photopolymerizable compound (B) contains the compound (B-4), the content ratio of the compound (B-4) is preferably 5% by mass or more, more preferably 10% by mass or more, still more preferably 20% by mass or more, yet still more preferably 25% by mass or more and preferably 85% by mass or less, more preferably 75% by mass or less, still more preferably 65% by mass or less and yet still more preferably 60% by mass or less, and particularly preferably 55% by mass or less, based on the total amount of the photopolymerizable compound (B), from the viewpoint of reducing the viscosity of the curable composition, from the viewpoint of increasing the outgoing light intensity of the cured film, and the like.

In the case where the photopolymerizable compound (B) contains the compound (B-4), the content ratio of the compound (B-4) is preferably 3% by mass or more and 50% by mass or less, more preferably 5% by mass or more and 45% by mass or less, still more preferably 10% by mass or more and 40% by mass or less, and yet still more preferably 10% by mass or more and 35% by mass or less, based on the total amount of the curable composition or the total amount of the solid content of the curable composition, from the viewpoint of reducing the viscosity of the curable composition, from the viewpoint of increasing the outgoing light intensity of the cured film, and the like.

The photopolymerizable compound (B) preferably contains a monofunctional (meth)acrylate monomer having one (meth)acryloyloxy group in the molecule (compound (B-1)). When the curable composition contains the compound (B-1), it is possible to reduce the viscosity of the curable composition and to improve the applicability.

From the viewpoint of suppressing the occurrence of outgassing from the cured film due to heat load or pressure reduction in a post step of forming a color conversion layer of a display device described later (the formation of a barrier layer or the like), the curable composition preferably contains a polymerizable compound, the volatilization amount of which is 10% by mass or less when the polymerizable compound is heated at 80°C for one hour. From the same viewpoint, the photopolymerizable compound (B) more preferably contains a compound that is the compound (B-1) and the volatilization amount of which is 10% by mass or less when the compound is heated at 80°C for one hour. The volatilization amount is preferably 8% by mass or less, more preferably 7% by mass or less, still more preferably 5% by mass or less, far still more preferably 3% by mass or less, yet still more preferably 2% by mass or less, and particularly preferably 1% by mass or less and may be 0.01% by mass or more or 0.1% by mass or more. The volatilization amount when the compound is heated at 80°C for one hour can be obtained by the following procedure by a dry weight method.

5 g of the photopolymerizable compound (B) is weighed on an aluminum cup and is then installed on a hot plate at 80°C for one hour. The volatilization amount (% by mass) is calculated according to the following formula from the initial weight (W0) and the weight after one hour (W1).

$$\text{Volatilization amount (\% by mass)} = 100 \times (W0 - W1)/W0$$

From the viewpoint of obtaining a cured film having a good outgoing light intensity, the curable composition preferably contains a polymerizable compound for which the glass transition temperature of a homopolymer thereof is -50°C or higher. From the same viewpoint, the photopolymerizable compound more preferably contains a compound that is the compound (B-1) and for which the glass transition temperature of a homopolymer thereof is -50°C or higher. The glass transition temperature is preferably -30°C or higher and more preferably -20°C or higher and may be 0°C or higher and 200°C or lower. As the glass transition temperature, a catalog value or a numerical value disclosed in a general physical property table may be used or the glass transition temperature may be measured with a commercially available differential scanning calorimeter or the like.

From the viewpoint of obtaining a cured film having a good outgoing light intensity, the curable composition preferably contains a compound that is the compound (B-1) and in which a group that is bonded to the (meth)acryloyloxy group is a hydrocarbon group not containing a hetero atom such as an oxygen atom or a nitrogen atom. The hydrocarbon group is more preferably a chain hydrocarbon group or an alicyclic hydrocarbon group.

In the case where the photopolymerizable compound (B) contains the compound (B-1), the content ratio of the compound (B-1) is preferably 5% by mass or more, more preferably 10% by mass or more, still more preferably 15% by mass or more, yet still more preferably 20% by mass or more, and particularly preferably 25% by mass or more and preferably 75% by mass or less, more preferably 65% by mass or less, still more preferably 60% by mass or less and yet still more preferably 55% by mass or less, and particularly preferably 50% by mass or less, based on the total amount

of the photopolymerizable compound (B), from the viewpoint of reducing the viscosity of the curable composition, and the like.

In the case where the photopolymerizable compound (B) contains the compound (B-1), the content ratio of the compound (B-1) is preferably 5% by mass or more and 50% by mass or less, more preferably 8% by mass or more and 45% by mass or less, still more preferably 10% by mass or more and 40% by mass or less, and yet still more preferably 15% by mass or more and 35% by mass or less, based on the total amount of the curable composition or the total amount of the solid content of the curable composition, from the viewpoint of reducing the viscosity of the curable composition, and the like.

The content ratio of the photopolymerizable compound (B) in the curable composition is, based on the total amount of the solid content of the curable composition, for example, 5% by mass or more and 80% by mass or less, preferably 7% by mass or more and 75% by mass or less, more preferably 10% by mass or more and 70% by mass or less, and still more preferably 13% by mass or more and 68% by mass or less. When the content ratio of the photopolymerizable compound (B) is within the above range, the solvent resistance (residual film ratio) of the cured film tends to improve.

From the viewpoint of improving the development speed of the curable composition, the content ratio of the photopolymerizable compound (B) is preferably 13% by mass or more, more preferably 15% by mass or more, and still more preferably 20% by mass or more, based on the total amount of the solid content of the curable composition.

[3] Photopolymerization initiator (C)

The curable composition may further contain one or more photopolymerization initiators (C). The photopolymerization initiator (C) is a compound capable of initiating polymerization by generating active radicals, acids and the like by the action of light and heat.

The photopolymerization initiator (C) preferably contains an oxime compound having a first molecular structure represented by the following formula (1). Hereinafter, the oxime compound is also referred to as "oxime compound (1)".

[Formula 1]

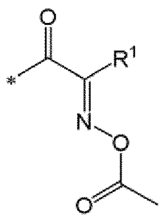

(1)

Containing the oxime compound (1) as the photopolymerization initiator (C) can be advantageous from the viewpoint of increasing the outgoing light intensity of the cured film. One of the reasons why the cured film can exhibit such an effect is presumed to be that the oxime compound (1) has a high ability to initiate photoradical polymerization, because the absorption wavelength of the oxime compound (1) changes greatly before and after cleavage (decomposition) of the oxime compound (1), which is necessary when the oxime compound (1) initiates photopolymerization, due to the unique molecular structure of the oxime compound (1).

In the formula (1), $R^1$ represents $R^{11}$, $OR^{11}$, $COR^{11}$, $SR^{11}$, $CONR^{12}R^{13}$, or CN.

$R^{11}$, $R^{12}$, and $R^{13}$ each independently represent a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

The hydrogen atoms of the group represented by $R^{11}$, $R^{12}$, or $R^{13}$ are optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{21}$, $R^{22}$, and $R^{23}$ each independently represent a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

The hydrogen atoms of the group represented by $R^{21}$, $R^{22}$, or $R^{23}$ are optionally replaced by CN, a halogen atom, a hydroxy group, or a carboxy group.

When the group represented by $R^{11}$, $R^{12}$, $R^{13}$, $R^{21}$, $R^{22}$, or $R^{23}$ has an alkylene moiety, the alkylene moiety is optionally interrupted one to five times by -O-, -S-, - COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.
When the group represented by $R^{11}$, $R^{12}$, $R^{13}$, $R^{21}$, $R^{22}$, or $R^{23}$ has an alkyl moiety, the alkyl moiety is optionally branched or cyclic, and $R^{12}$ and $R^{13}$, and $R^{22}$ and $R^{23}$ are each optionally joined together to form a ring.

* represents a bond with a second molecular structure which is a molecular structure other than the first molecular structure of the oxime compound (1).

Examples of alkyl groups having 1 to 20 carbon atoms represented by $R^{11}$, $R^{12}$, $R^{13}$, $R^{21}$, $R^{22}$, $R^{23}$, and $R^{24}$ in the formula (1) include a methyl group, an ethyl group, a propyl group, an isopropyl group, a butyl group, an isobutyl group, a sec-butyl group, a tert-butyl group, a pentyl group, an isopentyl group, a tert-pentyl group, a hexyl group, a heptyl group, an octyl group, an isooctyl group, a 2-ethylhexyl group, a tert-octyl group, a nonyl group, an isononyl group, a decyl group, an isodecyl group, an undecyl group, a dodecyl group, a tetradecyl group, a hexadecyl group, an octadecyl group, an icosyl group, a cyclopentyl group, a cyclohexyl group, a cyclohexylmethyl group, and a cyclohexylethyl group.
Examples of aryl groups having 6 to 30 carbon atoms represented by $R^{11}$, $R^{12}$, $R^{13}$, $R^{21}$, $R^{22}$, $R^{23}$, and $R^{24}$ in the formula (1) include a phenyl group, a tolyl group, a xylyl group, an ethylphenyl group, a naphthyl group, an anthryl group, a phenanthryl group; and a phenyl group, a biphenylyl group, a naphthyl group, and an anthryl group substituted with one or more of the alkyl groups.
Examples of aralkyl groups having 7 to 30 carbon atoms represented by $R^{11}$, $R^{12}$, $R^{13}$, $R^{21}$, $R^{22}$, $R^{23}$, and $R^{24}$ in the formula (1) include a benzyl group, an $\alpha$-methylbenzyl group, an $\alpha,\alpha$-dimethylbenzyl group, and a phenylethyl group.
Examples of the heterocyclic groups having 2 to 20 carbon atoms represented by $R^{11}$, $R^{12}$, $R^{13}$, $R^{21}$, $R^{22}$, $R^{23}$, and $R^{24}$ in the formula (1) include a pyridyl group, a pyrimidyl group, a furyl group, a thienyl group, a tetrahydrofuryl group, a dioxolanyl group, a benzoxazol-2-yl group, a tetrahydropyranyl group, a pyrrolidyl group, an imidazolidyl group, a pyrazolidyl group, a thiazolidyl group, an isothiazolidyl group, an oxazolidyl group, an isoxazolidyl group, a piperidyl group, a piperazyl group, and a morpholinyl group, and preferable is a 5- to 7-membered heterocyclic group.
$R^{12}$ and $R^{13}$ and $R^{22}$ and $R^{23}$ in the formula (1) are each optionally joined together to form a ring, meaning that $R^{12}$ and $R^{13}$ and $R^{22}$ and $R^{23}$ are each optionally joined together to form a ring together with a nitrogen atom, a carbon atom, or an oxygen atom to be connected.
Examples of the ring that can be formed by joining $R^{12}$ and $R^{13}$ and $R^{22}$ and $R^{23}$ in the formula (1) together include a cyclopentane ring, a cyclohexane ring, a cyclopentene ring, a benzene ring, a piperidine ring, a morpholine ring, a lactone ring, and a lactam ring, and preferable is a 5- to 7-membered ring.
Examples of the halogen atom that $R^{11}$, $R^{12}$, $R^{13}$, $R^{21}$, $R^{22}$, and $R^{23}$ in the formula (1) may have as a substituent include a fluorine atom, a chlorine atom, a bromine atom and an iodine atom.
$R^1$ in the formula (1) is preferably $R^{11}$, more preferably an alkyl group having 1 to 20 carbon atoms, still more preferably an alkyl group having 1 to 10 carbon atoms, and yet still more preferably an alkyl group having 1 to 6.
An example of the second molecular structure linked to the first molecular structure represented by the formula (1) is a structure represented by the following formula (2). The second molecular structure refers to a molecular structure portion of the oxime compound (1) other than the first molecular structure.
The bond represented by "*" in the formula (2) is directly bonded to the bond represented by "*" in the formula (1). That is, when the second molecular structure is a structure represented by the formula (2), the benzene ring having "-*" in the formula (2) and the carbonyl group having "-*" in the formula (1) are directly bonded to each other.

[Formula 2]

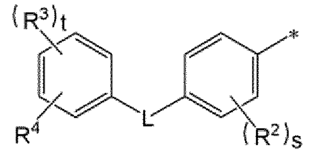

(2)

In the formula (2), $R^2$ and $R^3$ each independently represent $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, CN, or a halogen atom.
A plurality of $R^2$, when present, are optionally the same or different.
A plurality of $R^3$, when present, are optionally the same or different.
$R^{11}$, $R^{12}$, and $R^{13}$ have the same meaning as described above.
s and t each independently represent an integer of 0 to 4.
L represents a sulfur atom, $CR^{31}R^{32}$, CO, or $NR^{33}$.

$R^{31}$, $R^{32}$, and $R^{33}$ each independently represent a hydrogen atom, an alkyl group having 1 to 20 carbon atoms, an aryl group having 6 to 30 carbon atoms, or an aralkyl group having 7 to 30 carbon atoms.
When the group represented by $R^{31}$, $R^{32}$, or $R^{33}$ has an alkyl moiety, the alkyl moiety is optionally branched or cyclic, and $R^{31}$, $R^{32}$, and $R^{33}$ are each independently and optionally joined together to form a ring with any of adjacent benzene rings.
$R^4$ represents a hydroxy group, a carboxy group, or a group represented by the following formula (2-1):
[Formula 3]

$$(R^{4a})_v\text{-}L^2\text{-}L_1\text{-} \qquad (2\text{-}1)$$

(In the formula (2-1), $L^1$ represents -O-, -S-, $-NR^{22}-$, $-NR^{22}CO-$, $-SO_2-$, -CS-, -OCO-, or -COO-.
$R^{22}$ has the same meaning as described above.
$L^2$ represents a group obtained by removing v hydrogen atoms from an alkyl group having 1 to 20 carbon atoms, a group obtained by removing v hydrogen atoms from an aryl group having 6 to 30 carbon atoms, a group obtained by removing v hydrogen atoms from an aralkyl group having 7 to 30 carbon atoms, or a group obtained by removing v hydrogen atoms from a heterocyclic group having 2 to 20 carbon atoms.
When the group represented by $L^2$ has an alkylene moiety, the alkylene moiety is optionally interrupted one to five times by -O-, -S-, -COO-, -OCO-, $-NR^{22}-$, $-NR^{22}COO-$, $-OCONR^{22}-$, -SCO-, -COS-, -OCS-, or -CSO-, and the alkylene moiety is optionally branched or cyclic.
$R^{4a}$ is each independently $OR^{41}$, $SR^{41}$, $CONR^{42}R^{43}$, $NR^{42}COR^{43}$, $OCOR^{41}$, $COOR^{41}$, $SCOR^{41}$, $OCSR^{41}$, $COSR^{41}$, $CSOR^{41}$, CN, or a halogen atom.
A plurality of $R^{4a}$, when present, are optionally the same or different.
$R^{41}$, $R^{42}$, and $R^{43}$ each independently represent a hydrogen atom, an alkyl group having 1 to 20 carbon atoms, an aryl group having 6 to 30 carbon atoms, or an aralkyl group having 7 to 30 carbon atoms, and when the group represented by $R^{41}$, $R^{42}$, and $R^{43}$ has an alkyl moiety, the alkyl moiety is optionally branched or cyclic, and $R^{42}$ and $R^{43}$ are optionally joined together to form a ring.
v represents an integer of 1 to 3.)
* represents a bond with the first molecular structure of the oxime compound (1).

Examples of alkyl groups having 1 to 20 carbon atoms, aryl groups having 6 to 30 carbon atoms, and aralkyl groups having 7 to 30 carbon atoms represented by $R^{11}$, $R^{12}$, $R^{13}$, $R^{21}$, $R^{22}$, $R^{23}$, $R^{24}$, $R^{31}$, $R^{32}$, and $R^{33}$ in the formula (2) and $R^{22}$, $R^{41}$, $R^{42}$, and $R^{43}$ in the formula (2-1) are the same as examples for $R^{11}$, $R^{12}$, $R^{13}$, $R^{21}$, $R^{22}$, $R^{23}$, and $R^{24}$ in the formula (1).
Examples of heterocyclic groups having 2 to 20 carbon atoms represented by $R^{11}$, $R^{12}$, $R^{13}$, $R^{21}$, $R^{22}$, $R^{23}$, and $R^{24}$ in the formula (2) and $R^{22}$ in the formula (2-1) are the same as examples for $R^{11}$, $R^{12}$, $R^{13}$, $R^{21}$, $R^{22}$, $R^{23}$, and $R^{24}$ in the formula (1) .
$R^{31}$, $R^{32}$, and $R^{33}$ in the formula (2) are each independently and optionally joined together to form a ring with any of adjacent benzene rings, meaning that $R^{31}$, $R^{32}$, and $R^{33}$ are each independently and optionally joined together to form a ring with any of adjacent benzene rings together with a nitrogen atom to be connected.
Examples of the ring which can be formed by joining $R^{31}$, $R^{32}$, and $R^{33}$ in the formula (2) together with any of adjacent benzene rings are the same as those of the ring which can be formed by joining $Ra^{12}$ and $Ra^{13}$ and $Ra^{22}$ and $Ra^{23}$ in the formula (1) together.
$L^2$ in the above formula (2-1) represents groups obtained by removing v hydrogen atoms from an alkyl group having 1 to 20 carbon atoms, an aryl group having 6 to 30 carbon atoms, an aralkyl group having 7 to 30 carbon atoms, or a heterocyclic group having 2 to 20 carbon atoms.
Examples of the group obtained by removing v hydrogen atoms from an alkyl group having 1 to 20 carbon atoms when v is 1 include alkylene groups such as a methylene group, an ethylene group, a propylene group, a methylethylene group, a butylene group, a 1-methylpropylene group, a 2-methylpropylene group, a 1,2-dimethylpropylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, a decylene group, a dodecylene group, a tridecylene group, a tetradecylene group, a pentadecylene group, an ethane-1,1-diyl group, and a propane-2,2-diyl group.
Examples of the group obtained by removing v hydrogen atoms from an aryl group having 6 to 30 carbon atoms when v is 1 include arylene groups such as a 1,2-phenylene group, 1,3-phenylene group, and a 1,4-phenylene group, a 2,6-naphthylene group, a 1,4-naphthylene group, a 2,5-dimethyl-1,4-phenylene group, a diphenylmethane-4,4'-diyl group, a 2,2-diphenylpropane-4,4'-diyl group, a diphenylsulfide-4,4'-diyl group, and a diphenylsulfon-4,4'-diyl group.
Examples of the group obtained by removing v hydrogen atoms from an aralkyl group having 7 to 30 carbon

atoms when v is 1 include a group represented by the following formula (a) and a group represented by the following formula (b).

[Formula 4]

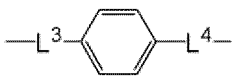 (a) 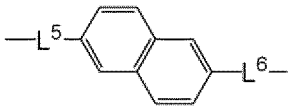 (b)

[In the formulas (a) and (b), $L^3$ and $L^5$ represent an alkylene group having 1 to 10 carbon atoms, and $L^4$ and $L^6$ represent a single bond or an alkylene group having 1 to 10 carbon atoms.]

Examples of the alkylene group having 1 to 10 carbon atoms include alkylene groups such as a methylene group, an ethylene group, a propylene group, a methylethylene group, a butylene group, a 1-methylpropylene group, a 2-methylpropylene group, a 1,2-dimethylpropylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, and a decylene group.

Examples of the group obtained by removing v hydrogen atoms from a heterocyclic group having 2 to 20 carbon atoms when v is 1 include divalent heterocyclic groups such as a 2,5-pyridinediyl group, a 2,6-pyridinediyl group, a 2,5-pyrimidinediyl group, a 2,5-thiophenediyl group, a 3,4-tetrahydrofurandiyl group, a 2,5-tetrahydrofurandiyl group, a 2,5-furandiyl group, a 3,4-thiazolediyl group, a 2,5-benzofurandiyl group, a 2,5-benzothiophenediyl group, an N-methylindole-2,5-diyl group, a 2,5-benzothiazolediyl group, and a 2,5-benzoxazolediyl group.

Examples of the halogen atom represented by $R^2$ and $R^3$ in the formula (2) and $R^{4a}$ in the formula (2-1) include a fluorine atom, a chlorine atom, a bromine atom and an iodine atom.

From the viewpoint of solubility in the solvent (G) and/or the development speed of the curable composition, a preferable example of the structure represented by the formula (2) is the structure represented by the following formula (2a):

[Formula 5]

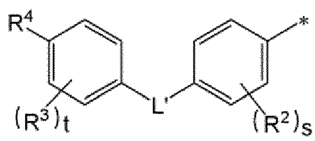 (2a)

[In the formula (2a), L' represents a sulfur atom or $NR^{50}$, $R^{50}$ represents a linear, branched, or cyclic alkyl group having 1 to 20 carbon atoms, and $R^2$, $R^3$, $R^4$, s, and t have the same meaning as described above.]

From the same viewpoint as above, another preferable example of the structure represented by the formula (2) is the structure represented by the following formula (2b) :

[Formula 6]

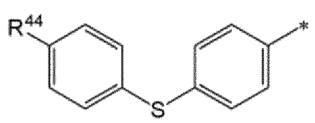 (2b)

[In the formula (2b), $R^{44}$ represents a hydroxy group, a carboxy group, or a group represented by the following formula (2-2):

[Formula 7]

$R^{44a}$-$L^{12}$-$L^{11}$- (2-2)

(In the formula (2-2), $L^{11}$ represents -O- or *-OCO-, * represents a bond to $L^{12}$, $L^{12}$ represents an alkylene group having 1 to 20 carbon atoms, the alkylene group may be interrupted by one to three -O-, $R^{44a}$ represents $OR^{55}$ or $COOR^{55}$, $R^{55}$ represents a hydrogen atom or an alkyl group having 1 to 6 carbon atoms.).]

$R^{44}$ is preferably a group represented by the formula (2-2). In this case, it is advantageous in terms of the solubility of the oxime compound (1) in the solvent (G) and the development speed of the curable composition.

The number of carbon atoms of the alkylene group represented by $L^{12}$ is preferably 1 to 10, and more preferably 1 to 4.

$R^{44a}$ is preferably a hydroxy group or a carboxy group, and more preferably a hydroxy group.

The method for producing the oxime compound (1) having the second molecular structure represented by the formula (2) is not particularly limited, but the oxime compound (1) can be produced by the method disclosed in Japanese Patent Laid-Open No. 2011-132215.

Another example of the second molecular structure linked to the first molecular structure represented by the formula (1) is a structure represented by the following formula (3).

The bond represented by "*" in the formula (3) is directly bonded to the bond represented by "*" in the formula (1). That is, when the second molecular structure is a structure represented by the formula (3), the benzene ring having "-*" in the formula (3) and the carbonyl group having "-*" in the formula (1) are directly bonded to each other.

[Formula 8]

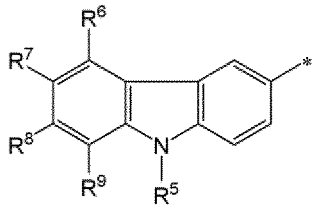

(3)

In the formula (3), $R^5$ represents a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

When the group represented by $R^5$ has an alkyl moiety, the alkyl moiety is optionally branched or cyclic.

The hydrogen atoms of the group represented by $R^5$ are optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxyl group, a nitro group, CN, a halogen atom, or $COOR^{21}$.

$R^{21}$, $R^{22}$, and $R^{23}$ have the same meaning as described above.

The hydrogen atoms of the group represented by $R^{21}$, $R^{22}$, or $R^{23}$ are optionally replaced by CN, a halogen atom, a hydroxy group, or a carboxy group.

When the group represented by $R^{21}$, $R^{22}$, and $R^{23}$ has an alkylene moiety, the alkylene moiety is optionally interrupted one to five times by -O-, -S-, -COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, and $R^{23}$ has an alkyl moiety, the alkyl moiety is optionally branched or cyclic, and $R^{22}$ and $R^{23}$ are optionally joined together to form a ring.

$R^6$, $R^7$, $R^8$, and $R^9$ are each independently $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

The hydrogen atoms of the group represented by $R^{61}$, $R^{62}$, $R^{63}$, $R^{64}$, or $R^{65}$ are optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=NOR^{21})-R^{22}$, $-C(=N-OCOR^{21})-R^{22}$, CN, a halogen atom, or $COOR^{21}$.

$R^6$ and $R^7$, $R^7$ and $R^8$, and $R^8$ and $R^9$ are each optionally joined together to form a ring.

* represents a bond with the first molecular structure of the oxime compound (1).

Examples of alkyl groups having 1 to 20 carbon atoms, aryl groups having 6 to 30 carbon atoms, aralkyl groups having 7 to 30 carbon atoms, and heterocyclic groups having 2 to 20 carbon atoms represented by $R^5$, $R^{21}$, $R^{22}$, $R^{23}$, $R^{24}$, $R^{61}$, $R^{62}$, $R^{63}$, $R^{64}$, and $R^{65}$ in the formula (3) are the same as examples for $R^{11}$, $R^{12}$, $R^{13}$, $R^{21}$, $R^{22}$, $R^{23}$, and $R^{24}$ in the formula (1) .

$R^{22}$ and $R^{23}$ in the formula (3) are each optionally joined together to form a ring, meaning that $R^{22}$ and $R^{23}$ are each optionally joined together to form a ring together with a nitrogen atom, a carbon atom, or an oxygen atom to be

connected.

Examples of the ring which can be formed by joining $R^{22}$ and $R^{23}$ in the formula (3) together are the same as those of the ring which can be formed by joining $Ra^{12}$ and $Ra^{13}$, and $Ra^{22}$ and $Ra^{23}$ in the formula (1) together.

Examples of the halogen atom represented by $R^6$, $R^7$, $R^8$, and $R^9$, and the halogen atoms which may replace the hydrogen atoms of $R^5$, $R^{21}$, $R^{22}$, $R^{23}$, $R^{61}$, $R^{62}$, $R^{63}$, $R^{64}$, and $R^{65}$ in the formula (3) include a fluorine atom, a chlorine atom, a bromine atom and an iodine atom.

From the viewpoint of solubility in the solvent (G) and/or the development speed of the curable composition, in one preferable embodiment, $R^5$ is a group represented by the following formula (3-1):

[Formula 9]

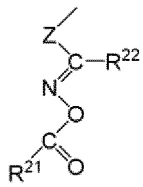

(3-1)

[In the formula (3-1), Z represents a group obtained by removing one hydrogen atom from an alkyl group having 1 to 20 carbon atoms, a group obtained by removing one hydrogen atom from an aryl group having 6 to 30 carbon atoms, a group obtained by removing one hydrogen atom from an aralkyl group having 7 to 30 carbon atoms, or a group obtained by removing one hydrogen atom from a heterocyclic group having 2 to 20 carbon atoms.

When the group represented by Z has an alkylene moiety, the alkylene moiety is optionally interrupted one to five times by -O-, -S-, -COO-, -OCO-, $-NR^{24}-$, $-NR^{24}COO-$, $-OCONR^{24}-$, -SCO-, -COS-, -OCS-, or -CSO-, and the alkylene moiety is optionally branched or cyclic.

$R^{21}$, $R^{22}$, and $R^{24}$ have the same meaning as described above.]

From the same viewpoint as above, Z in the formula (3-1) is preferably a methylene group, an ethylene or phenylene group.

From the same viewpoint as above, $R^{21}$ and $R^{22}$ in the formula (3-1) are preferably an alkyl group having 1 to 20 carbon atoms or an aryl group having 6 to 30 carbon atoms, and more preferably a methyl group, an ethyl group, or a phenyl group.

From the same viewpoint as above, in another preferred embodiment, $R^7$ is a nitro group.

The method for producing the oxime compound (1) having the second molecular structure represented by the formula (3) is not particularly limited, but the oxime compound (1) can be produced by the method disclosed in Japanese Patent Laid-Open No. 2000-80068 and Japanese Patent Laid-Open No. 2011-178776.

Yet another example of the second molecular structure linked to the first molecular structure represented by the formula (1) is a structure represented by the following formula (4).

The bond represented by "*" in the formula (4) is directly bonded to the bond represented by "*" in the formula (1). That is, when the second molecular structure is a structure represented by the formula (4), the benzene ring having "-*" in the formula (4) and the carbonyl group having "-*" in the formula (1) are directly bonded to each other.

[Formula 10]

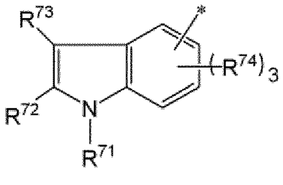

(4)

In the formula (4), $R^{71}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

When the group represented by $R^{71}$ has an alkyl moiety, the alkyl moiety is optionally branched or cyclic.

The hydrogen atoms of the group represented by $R^{71}$ are optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, -C(=N-

$OCOR^{21}$)-$R^{22}$, $SCOR^{21}$, $OCSR^{21}$, $COSR^{21}$, $CSOR^{21}$, a hydroxyl group, a nitro group, CN, a halogen atom, or $COOR^{21}$.

$R^{21}$, $R^{22}$, and $R^{23}$ have the same meaning as described above.

The hydrogen atoms of the group represented by $R^{21}$, $R^{22}$, or $R^{23}$ are optionally replaced by CN, a halogen atom, a hydroxy group, or a carboxy group.

When the group represented by $R^{21}$, $R^{22}$, and $R^{23}$ has an alkylene moiety, the alkylene moiety is optionally interrupted one to five times by -O-, -S-, -COO-, -OCO-, -$NR^{24}$-, -$NR^{24}$CO-, -$NR^{24}$COO-, -OCONR$^{24}$-, -SCO-, -COS-, -OCS-, or-CSO-.

$R^{24}$ has the same meaning as described above.

When the group represented by $R^{21}$, $R^{22}$, and $R^{23}$ has an alkyl moiety, the alkyl moiety is optionally branched or cyclic, and $R^{22}$ and $R^{23}$ are optionally joined together to form a ring.

$R^{72}$, $R^{73}$, and three $R^{74}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

The hydrogen atoms of the group represented by $R^{61}$, $R^{62}$, $R^{63}$, $R^{64}$, or $R^{65}$ are optionally replaced by $OR^{21}$, $COR^{21}$, $SR^{21}$, $NR^{22}Ra^{23}$, $CONR^{22}R^{23}$, -$NR^{22}$-$OR^{23}$, -N($COR^{22}$)-$OCOR^{23}$, -C (=$NOR^{21}$)-$R^{22}$, -C(=N-$OCOR^{21}$)-$R^{22}$, CN, a halogen atom, or $COOR^{21}$.

$R^{72}$ and $R^{73}$ and two $R^{74}$ are each optionally joined together to form a ring.

* represents a bond with the first molecular structure of the oxime compound (1).

Examples of alkyl groups having 1 to 20 carbon atoms, aryl groups having 6 to 30 carbon atoms, aralkyl groups having 7 to 30 carbon atoms, and heterocyclic groups having 2 to 20 carbon atoms represented by $R^{71}$, $R^{21}$, $R^{22}$, $R^{23}$, $R^{24}$, $R^{61}$, $R^{62}$, $R^{63}$, $R^{64}$, and $R^{65}$ in the formula (4) are the same as examples for $R^{11}$, $R^{12}$, $R^{13}$, $R^{21}$, $R^{22}$, $R^{23}$, and $R^{24}$ in the formula (1) .

$R^{22}$ and $R^{23}$ in the formula (4) are each optionally joined together to form a ring, meaning that $R^{22}$ and $R^{23}$ are each optionally joined together to form a ring together with a nitrogen atom, a carbon atom, or an oxygen atom to be connected.

Examples of the ring which can be formed by joining $R^{22}$ and $R^{23}$ in the formula (4) together are the same as those of the ring which can be formed by joining $Ra^{12}$ and $Ra^{13}$, and $Ra^{22}$ and $Ra^{23}$ in the formula (1) together.

Examples of the halogen atom represented by $R^{72}$, $R^{73}$, and $R^{74}$, and the halogen atoms which may replace the hydrogen atoms of $R^{71}$, $R^{21}$, $R^{22}$, $R^{23}$, $R^{61}$, $R^{62}$, $R^{63}$, $R^{64}$, and $R^{65}$ in the formula (4) include a fluorine atom, a chlorine atom, a bromine atom and an iodine atom.

The method for producing the oxime compound (1) having the second molecular structure represented by the formula (4) is not particularly limited, but the oxime compound (1) can be produced by the method disclosed in International Publication No. 2017/051680 and International Publication No. 2020/004601.

Yet another example of the second molecular structure linked to the first molecular structure represented by the formula (1) is a structure represented by the following formula (5).

The bond represented by "*" in the formula (5) is directly bonded to the bond represented by "*" in the formula (1). That is, when the second molecular structure is a structure represented by the formula (5), the pyrrole ring having "-*" in the formula (5) and the carbonyl group having "-*" in the formula (1) are directly bonded to each other.

[Formula 11]

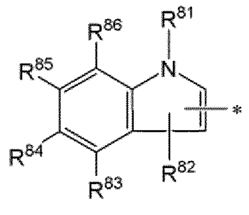

(5)

In the formula (5), $R^{81}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

When the group represented by $R^{81}$ has an alkyl moiety, the alkyl moiety is optionally branched or cyclic.

The hydrogen atoms of the group represented by $R^{81}$ are optionally replaced by $R^{21}$, $OR^{21}$, $COR^{21}$, $SR^{21}$,

$NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxyl group, a nitro group, CN, a halogen atom, or $COOR^{21}$.

$R^{21}$, $R^{22}$, and $R^{23}$ have the same meaning as described above.

The hydrogen atoms of the group represented by $R^{21}$, $R^{22}$, or $R^{23}$ are optionally replaced by CN, a halogen atom, a hydroxy group, or a carboxy group.

When the group represented by $R^{21}$, $R^{22}$, and $R^{23}$ has an alkylene moiety, the alkylene moiety is optionally interrupted one to five times by -O-, -S-, -COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, and $R^{23}$ has an alkyl moiety, the alkyl moiety is optionally branched or cyclic, and $R^{22}$ and $R^{23}$ are optionally joined together to form a ring.

$R^{82}$, $R^{83}$, $R^{84}$, $R^{85}$, and $R^{86}$ are each independently $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

The hydrogen atoms of the group represented by $R^{61}$, $R^{62}$, $R^{63}$, $R^{64}$, or $R^{65}$ are optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C (=NOR^{21})-R^{22}$, $-C(=N-OCOR^{21})-R^{22}$, CN, a halogen atom, or $COOR^{21}$.

$R^{83}$ and $R^{84}$, $R^{84}$ and $R^{85}$, and $R^{85}$ and $R^{86}$ are each optionally joined together to form a ring.

* represents a bond with the first molecular structure of the oxime compound (1).

Examples of alkyl groups having 1 to 20 carbon atoms, aryl groups having 6 to 30 carbon atoms, aralkyl groups having 7 to 30 carbon atoms, and heterocyclic groups having 2 to 20 carbon atoms represented by $R^{81}$, $R^{21}$, $R^{22}$, $R^{23}$, $R^{24}$, $R^{61}$, $R^{62}$, $R^{63}$, $R^{64}$, and $R^{65}$ in the formula (5) are the same as examples for $R^{11}$, $R^{12}$, $R^{13}$, $R^{21}$, $R^{22}$, $R^{23}$, and $R^{24}$ in the formula (1) .

$R^{22}$ and $R^{23}$ in the formula (5) are each optionally joined together to form a ring, meaning that $R^{22}$ and $R^{23}$ are each optionally joined together to form a ring together with a nitrogen atom, a carbon atom, or an oxygen atom to be connected.

Examples of the ring which can be formed by joining $R^{22}$ and $R^{23}$ in the formula (5) together are the same as those of the ring which can be formed by joining $Ra^{12}$ and $Ra^{13}$, and $Ra^{22}$ and $Ra^{23}$ in the formula (1) together.

Examples of the halogen atom represented by $R^{82}$, $R^{83}$, $R^{84}$, $R^{85}$, and $R^{86}$, and the halogen atoms which may replace the hydrogen atoms of $R^{81}$, $R^{21}$, $R^{22}$, $R^{23}$, $R^{61}$, $R^{62}$, $R^{63}$, $R^{64}$, and $R^{65}$ in the formula (5) include a fluorine atom, a chlorine atom, a bromine atom and an iodine atom.

The method for producing the oxime compound (1) having the second molecular structure represented by the formula (5) is not particularly limited, but the oxime compound (1) can be produced by the method disclosed in International Publication No. 2017/051680 and International Publication No. 2020/004601.

Yet another example of the second molecular structure linked to the first molecular structure represented by the formula (1) is a structure represented by the following formula (6).

The bond represented by "*" in the formula (6) is directly bonded to the bond represented by "*" in the formula (1). That is, when the second molecular structure is a structure represented by the formula (6), the benzene ring having "-*" in the formula (6) and the carbonyl group having "-*" in the formula (1) are directly bonded to each other.

[Formula 12]

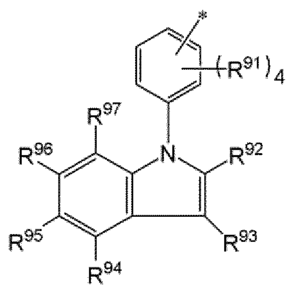

(6)

In the formula (6), four $R^{91}$, $R^{92}$, $R^{93}$, $R^{94}$, $R^{95}$, $R^{96}$, and $R^{97}$ are each independently $R^{61}$, $OR^{61}$, $SR^{61}$, $COR^{62}$,

$CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

The hydrogen atoms of the group represented by $R^{61}$, $R^{62}$, $R^{63}$, $R^{64}$, or $R^{65}$ are optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=NOR^{21})-R^{22}$, $-C(=N-OCOR^{21})-R^{22}$, CN, a halogen atom, or $COOR^{21}$.

$R^{21}$, $R^{22}$, and $R^{23}$ have the same meaning as described above.

$R^{92}$ and $R^{93}$, $R^{94}$ and $R^{95}$, $R^{95}$ and $R^{96}$, and $R^{96}$ and $R^{97}$ are each optionally joined together to form a ring.

* represents a bond with the first molecular structure of the oxime compound (1).

Examples of alkyl groups having 1 to 20 carbon atoms, aryl groups having 6 to 30 carbon atoms, aralkyl groups having 7 to 30 carbon atoms, and heterocyclic groups having 2 to 20 carbon atoms represented by $R^{21}$, $R^{22}$, $R^{23}$, $R^{61}$, $R^{62}$, $R^{63}$, $R^{64}$, and $R^{65}$ in the formula (6) are the same as examples for $R^{11}$, $R^{12}$, $R^{13}$, $R^{21}$, $R^{22}$, and $R^{23}$ in the formula (1).

$R^{22}$ and $R^{23}$ in the formula (6) are each optionally joined together to form a ring, meaning that $R^{22}$ and $R^{23}$ are each optionally joined together to form a ring together with a nitrogen atom, a carbon atom, or an oxygen atom to be connected.

Examples of the ring which can be formed by joining $R^{22}$ and $R^{23}$ in the formula (6) together are the same as those of the ring which can be formed by joining $Ra^{12}$, and $Ra^{13}$ and $Ra^{22}$ and $Ra^{23}$ in the formula (1) together.

Examples of the halogen atom represented by $R^{91}$, $R^{92}$, $R^{93}$, $R^{94}$, $R^{95}$, $R^{96}$, and $R^{97}$, and the halogen atoms which may replace the hydrogen atoms of $R^{21}$, $R^{22}$, $R^{23}$, $R^{61}$, $R^{62}$, $R^{63}$, $R^{64}$, and $R^{65}$ in the formula (6) include a fluorine atom, a chlorine atom, a bromine atom and an iodine atom.

The method for producing the oxime compound (1) having the second molecular structure represented by the formula (6) is not particularly limited, but the oxime compound (1) can be produced by the method disclosed in International Publication No. 2017/051680 and International Publication No. 2020/004601.

The photopolymerization initiator (C) may further contain another photopolymerization initiator other than the oxime compound (1).

Examples of the other photopolymerization initiator include oxime compounds other than the oxime compound (1), alkylphenone compounds, biimidazole compounds, triazine compounds and acylphosphine compounds.

Examples of the oxime compound other than the oxime compound (1) include an oxime compound having a partial structure represented by the following formula (d1). * represents a bond.

[Formula 13]

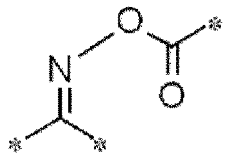

(d1)

Examples of the oxime compound having a partial structure represented by the formula (d1) include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, and N-benzoyloxy-1-[9-ethyl-6-(2-methylbenzoyl)-9H-carbazole-3-yl]-3-cyclopentylpropan-1-one-2-imine, and compounds disclosed in Japanese Patent Laid-Open No. 2011-132215, International Publication No. 2008/78678, International Publication No. 2008/78686, and International Publication No. 2012/132558. Commercially available products such as Irgacure OXE01 and Irgacure OXE02 (all manufactured by BASF Japan Ltd.), and N-1919 (manufactured by ADEKA Corporation) may also be used.

Of these, the oxime compound having a partial structure represented by the formula (d1) is preferably at least one selected from the group consisting of N-benzoyloxy-1-(4-phenylsulfanylphenyl)butan-1-one-2-imine, N-benzoyloxy-1-(4-phenylsulfanylphenyl)octan-1-one-2-imine, and N-benzoyloxy-1-(4-phenylsulfanylphenyl)-3-cyclopentylpropan-1-one-2-imine, and more preferably N-benzoyloxy-1-(4-phenylsulfanylphenyl)octan-1-one-2-imine.

The alkylphenone compounds are compounds having a partial structure represented by the following formula

(d4) or a partial structure represented by the following formula (d5). In these partial structures, the benzene ring may have a substituent.

[Formula 14]

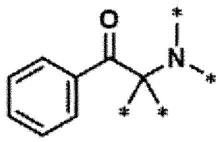 (d4)

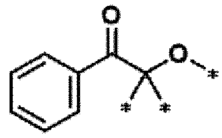 (d5)

Examples of the compounds having a structure represented by the formula (d4) include 2-methyl-2-morpholino-1-(4-methylsulfanylphenyl)propan-1-one, and 2-dimethylamino-1-(4-morpholinophenyl)-2-benzylbutan-1-one, 2-(dimethylamino)-2-[(4-methylphenyl)methyl]-1-[4-(4-morpholinyl)phenyl]butan-1-one. Commercially available products such as OMNIRAD 369, OMNIRAD 907, and OMNIRAD 379 (all manufactured by IGM Resins B.V.) may also be used.

Examples of the compounds having a structure represented by the formula (d5) include oligomers of 2-hydroxy-2-methyl-1-phenylpropan-1-one, 2-hydroxy-2-methyl-1-[4-(2-hydroxyethoxy)phenyl]propan-1-one, 1-hydroxycyclohexylphenyl ketone and 2-hydroxy-2-methyl-1-(4-isopropenylphenyl)propan-1-one, $\alpha,\alpha$-diethoxyacetophenone, and benzyl dimethyl ketal.

From the viewpoint of sensitivity, the alkylphenone compounds are preferably the compounds having a structure represented by the formula (d4).

Examples of the biimidazole compound include a compound represented by the formula (d6).

[Formula 15]

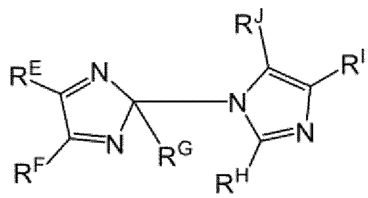 (d6)

[In the formula (d6), $R^E$ to $R^J$ represent an aryl group having 6 to 10 carbon atoms which may have a substituent.]

Examples of the aryl group having 6 to 10 carbon atoms include a phenyl group, a toluyl group, a xylyl group, an ethylphenyl group, and a naphthyl group, and preferable is a phenyl group.

Examples of the substituent include a halogen atom and an alkoxy group having 1 to 4 carbon atoms. Examples of the halogen atom include a fluorine atom, a chlorine atom, a bromine atom and an iodine atom, and preferable is a chlorine atom. Examples of the alkoxy group having 1 to 4 carbon atoms include a methoxy group, an ethoxy group, a propoxy group, and a butoxy group, and preferable is a methoxy group.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 06-75372 and Japanese Patent Laid-Open No. 06-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and an imidazole compound in which phenyl groups at the 4,4',5,5' positions are each substituted with a carboalkoxy group (for example, see Japanese Patent Laid-Open No. 7-10913). Of these, a compound represented by the following formula or a mixture thereof is preferable.

[Formula 16]

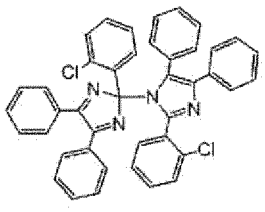 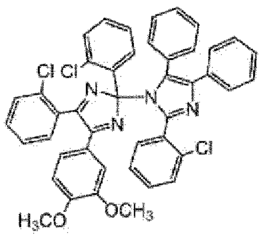 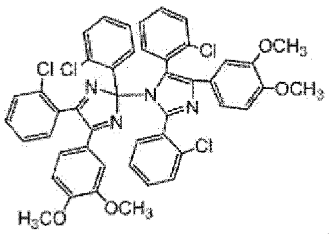

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine. Of these, 2,4-bis(trichloromethyl)-6-piperonyl-1,3,5-triazine is preferable.

Examples of the acylphosphine compound include bis(2,4,6-trimethylbenzoyl)phenylphosphine oxide and (2,4,6-trimethylbenzoyl)diphenylphosphine oxide.

Other examples of the other photopolymerization initiator other than the oxime compound (1) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, 2,4,6-trimethylbenzophenone, and 4,4'-bis(diethylamino)benzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound.

Only one photopolymerization initiator other than the oxime compound (1) may be used alone, or two or more photopolymerization initiators may be used in combination. When a photopolymerization initiator other than the oxime compound (1) is used in combination with the oxime compound (1), the other photopolymerization initiator may be an oxime compound other than the oxime compound (1), an alkylphenone compound, a biimidazole compound, a triazine compound, an acylphosphine compound, or the like.

In the case where the curable composition contains the photopolymerization initiator (C), The content of the photopolymerization initiator (C) in the curable composition is preferably 0.1 parts by mass or more and 300 parts by mass or less, and more preferably 0.1 parts by mass or more and 200 parts by mass or less, based on 100 parts by mass of the photopolymerizable compound (B). When the content of the photopolymerization initiator (C) is within the above range, the productivity of the cured film tends to improve.

[4] Resin (D)

The curable composition may further contain a resin (D). As the resin (D), one or more resins can be further contained. Examples of the resin (D) include the following resins [K1] to [K4]:

resin [K1]: copolymer of at least one (a) (hereinafter also referred to as "(a)") selected from the group consisting of an unsaturated carboxylic acid and an unsaturated carboxylic acid anhydride and a monomer (c) (hereinafter also referred to as "(c)") copolymerizable with (a) (but different from (a));
resin [K2]: resin obtained by reacting a copolymer of (a) and (c) with a monomer (b) (hereinafter also referred to as "(b)") having a cyclic ether structure having 2 to 4 carbon atoms and an ethylenically unsaturated bond;
resin [K3]: resin obtained by reacting a copolymer of (b) and (c) with (a); and
resin [K4]: resin obtained by reacting a copolymer of (b) and (c) with (a) and further reacting with a carboxylic acid anhydride.

Examples of (a) include unsaturated monocarboxylic acids such as (meth)acrylic acid, crotonic acid, and o-, m-, and p-vinylbenzoic acid;

unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
bicyclo unsaturated compounds containing a carboxy group, such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;

unsaturated dicarboxylic acid anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride;

unsaturated mono[(meth)acryloyloxyalkyl]esters of di- or higher polycarboxylic acids such as mono[2-(meth)acryloyloxyethyl]succinate and mono[2-(meth)acryloyoxyethyl]phthalate; and

unsaturated (meth)acrylates containing a hydroxy group and a carboxy group in the same molecule, such as α-(hydroxymethyl) (meth)acrylic acid.

Of these, (meth)acrylic acid, maleic anhydride and the like are preferable from the viewpoint of copolymerization reactivity and solubility of the obtained resin (D) in an alkaline aqueous solution.

(b) is, for example, a monomer having a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether structure having 2 to 4 carbon atoms and a (meth)acryloyloxy group.

Examples of (b) include monomers having an oxirane ring and an ethylenically unsaturated bond, such as glycidyl (meth)acrylate, β-methylglycidyl (meth)acrylate, β-ethylglycidyl (meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl) styrene, 2,6-bis(glycidyloxymethyl)styrene, 2,3,4-tris(glycidyloxymethyl) styrene, 2,3,5-tris(glycidyloxymethyl)styrene, 2,3,6-tris(glycidyloxymethyl) styrene, 3,4,5-tris(glycidyloxymethyl)styrene, and 2,4,6-tris(glycidyloxymethyl) styrene;

monomers having an oxetane ring and an ethylenically unsaturated bond, such as 3-methyl-3-methacryloyloxymethyloxetane, 3-methyl-3-acryloyloxymethyloxetane, 3-ethyl-3-methacryloyloxymethyloxetane, 3-ethyl-3-acryloyloxymethyloxetane, 3-methyl-3-methacryloyloxyethyloxetane, 3-methyl-3-acryloyloxyethyloxetane, 3-ethyl-3-methacryloyloxyethyloxetane, and 3-ethyl-3-acryloyloxyethyloxetane; and

monomers having a tetrahydrofuran ring and an ethylenically unsaturated bond, such as tetrahydrofurfuryl acrylate (for example, Viscoat V#150, manufactured by OSAKA ORGANIC CHEMICAL INDUSTRY LTD.) and tetrahydrofurfuryl methacrylate.

(b) is preferably a monomer having an oxirane ring and an ethylenically unsaturated bond, because the reactivity during the production of the resins [K2] to [K4] is high and unreacted (b) hardly remains.

Examples of (c) include (meth)acrylic esters such as methyl (meth)acrylate, ethyl (meth)acrylate, n-butyl (meth)acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, tricyclo[5.2.1.$0^{2,6}$]decan-8-yl (meth)acrylate (referred to as "dicyclopentanyl (meth)acrylate" as a common name in the technical field. Or sometimes referred to as "tricyclodecyl (meth)acrylate"), tricyclo [5.2.1.$0^{2,6}$]decen-8-yl (meth)acrylate (which is referred to as "dicyclopentenyl (meth)acrylate" (common name) in the art), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, and benzyl (meth)acrylate;

hydroxy group-containing (meth)acrylic esters such as 2-hydroxyethyl (meth)acrylate and 2-hydroxypropyl (meth)acrylate;

dicarboxylic diesters such as diethyl maleate, diethyl fumarate, and diethyl itaconate;

bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;

dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide; and

styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance of the resin (D), styrene, vinyltoluene, N-phenylmaleimide, N-cyclohexylmaleimide, N-benzylmaleimide, bicyclo[2.2.1]hept-2-ene and the like are preferable.

In the resin [K1], the ratio of the structural unit derived from each of (a) and (c) in the total structural units constituting the resin [K1] is preferably the following:

the structural unit derived from (a): 2 mol% or more and 60 mol% or less; and
the structural unit derived from (c): 40 mol% or more and 98 mol% or less

and more preferably the following:

the structural unit derived from (a): 10 mol% or more and 50 mol% or less; and
the structural unit derived from (c): 50 mol% or more and 90 mol% or less.

When the ratio of the structural units of the resin [K1] is within the above range, the curable composition tends to be excellent in storage stability, and the cured film tends to be excellent in developability and solvent resistance.

The resin [K1] can be produced with reference to the method disclosed in for example, a document "Experimental Method for Polymer Synthesis" (edited by Takayuki Otsu, published by Kagaku-Dojin Publishing Company, INC, First Edition, First Printed on Mar. 1, 1972) and cited documents described in the above-mentioned document.

Specific examples thereof include the following method: predetermined amounts of (a) and (c), a polymerization initiator, a solvent and the like are placed in a reaction vessel; for example, a deoxidization atmosphere is formed by replacing oxygen with nitrogen; and these are heated or kept warm during stirring.

The polymerization initiator, the solvent and the like which are used here are not particularly limited, and those commonly used in the art can be used. Examples of the polymerization initiator include azo compounds (2,2'-azobisisobutyronitrile, 2,2'-azobis(2,4-dimethylvaleronitrile) and the like) and organic peroxides (benzoyl peroxide and the like), and the solvent may be a solvent capable of dissolving each monomer, and examples of the solvent (G) that is contained in the curable composition include solvents to be described later.

A solution after a reaction, of the resultant copolymer may be used as it is; a concentrated or diluted solution of the copolymer may be used; or a solid (powder) taken out from the copolymer by a method such as reprecipitation may be used. When the solvent (G) described later is used as the solvent for the polymerization, the solution after the reaction can be used as it is for the preparation of the curable composition, whereby the producing process of the curable composition can be simplified.

The resin [K2] can be produced by adding a cyclic ether having 2 to 4 carbon atoms of (b) to the copolymer of (a) and (c), that is, to a carboxylic acid and/or a carboxylic acid anhydride of (a).

The copolymer of (a) and (c) is first produced in the same manner as in the method described as the method for producing the resin [K1]. In this case, the ratio of the structural unit derived from each of (a) and (c) is preferably the same ratio as that described in the resin [K1] .

Next, a cyclic ether having 2 to 4 carbon atoms of (b) is reacted with a part of the carboxylic acid and/or the carboxylic acid anhydride derived from (a) in the copolymer.

Subsequent to the production of the copolymer of (a) and (c), the resin [K2] can be produced by replacing a nitrogen atmosphere in a flask with air, and reacting (b) in the presence of a reaction catalyst for a carboxylic acid or a carboxylic acid anhydride and a cyclic ether (for example, an organic phosphorus compound, a metallic complex, or an amine compound), and a polymerization inhibitor (for example, hydroquinone and the like), for example, at 60°C or more and 130°C or less for 1 to 10 hours.

The amount of (b) used is preferably 5 mol or more and 80 mol or less, and more preferably 10 mol or more and 75 mol or less, based on 100 mol of (a). Within this range, the storage stability of the curable composition, the developability of the cured film, and the solvent resistance, heat resistance, and mechanical strength of the cured film tend to be well balanced.

Examples of the organic phosphorus compound as a reaction catalyst include triphenylphosphine. As the amine compound as the reaction catalyst, for example, an aliphatic tertiary amine compound or an aliphatic quaternary ammonium salt compound can be used, and specific examples thereof include tris(dimethylaminomethyl)phenol, triethylamine, tetrabutylammonium bromide, and tetrabutylammonium chloride. From the viewpoint of the developability of the cured film and the outgoing light intensity of the cured film, the reaction catalyst is preferably an organic phosphorus compound.

The amount of the reaction catalyst used is preferably 0.001 part by mass or more and 5 parts by mass or less based on 100 parts by mass of the total amount of (a), (b), and (c).

The amount of the polymerization inhibitor used is preferably 0.001 part by mass or more and 5 parts by mass or less based on 100 parts by mass of the total amount of (a), (b), and (c).

The reaction conditions such as the charging method, the reaction temperature and the time can be appropriately adjusted in consideration of the production equipment, the amount of heat generated by the polymerization, and the like. In the same manner as the polymerization conditions, the charging method and the reaction temperature can be appropriately adjusted in consideration of the production equipment, the amount of heat generated by the polymerization, and the like.

The resin [K3] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural unit derived from each of (b) and (c) based on the total number of moles of the total structural units constituting the copolymer is preferably the following:

the structural unit derived from (b): 5 mol% or more and 95 mol% or less; and
the structural unit derived from (c): 5 mol% or more and 95 mol% or less

and more preferably the following:

the structural unit derived from (b): 10 mol% or more and 90 mol% or less; and
the structural unit derived from (c): 10 mol% or more and 90 mol% or less.

The resin [K3] can be produced by reacting a carboxylic acid or a carboxylic acid anhydride of (a) with the cyclic ether derived from (b) contained in the copolymer of (b) and (c) under the same conditions as those of the method for producing the resin [K2].

The amount of (a) used which is reacted with the copolymer is preferably 5 mol or more and 80 mol or less based on 100 mol of (b).

The resin [K4] is a resin obtained by further reacting the resin [K3] with a carboxylic acid anhydride. A carboxylic acid anhydride is reacted with a hydroxy group generated by a reaction between a cyclic ether and a carboxylic acid or a carboxylic anhydride.

Examples of the carboxylic acid anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride.

The amount of the carboxylic acid anhydride used is preferably 0.5 mol or more and 1 mol or less based on 1 mol of the amount used in (a).

Specific examples of the resin (K1), the resin (K2), the resin (K3), and the resin (K4) include a resin [K1] such as a benzyl (meth)acrylate/(meth)acrylic acid copolymer and a styrene/(meth)acrylic acid copolymer;
a resin [K2] such as a resin produced by adding glycidyl (meth)acrylate to a benzyl (meth)acrylate/(meth)acrylic acid copolymer, a resin produced by adding glycidyl (meth)acrylate to a tricyclodecyl (meth)acrylate/styrene/(meth)acrylic acid copolymer, or a resin produced by adding glycidyl (meth)acrylate to a tricyclodecyl (meth)acrylate/benzyl (meth)acrylate/(meth)ac rylic acid copolymer; a resin [K3] such as a resin produced by reacting a tricyclodecyl (meth)acrylate/glycidyl (meth)acrylate copolymer with (meth)acrylic acid or a resin produced by reacting a tricyclodecyl (meth)acrylate/styrene/glycidyl (meth)acrylate copolymer with (meth)acrylic acid; and a resin [K4] such as a resin produced by reacting a tricyclodecyl (meth)acrylate/glycidyl (meth)acrylate copolymer with (meth)acrylic acid to produce a resin and then reacting this resin with tetrahydrophthalic anhydride.

In particular, the resin (D) preferably contains at least one selected from the group consisting of the resin [K2], the resin [K3], and the resin [K4].

As a further example of the resin (D), the alkali-soluble resin disclosed in Japanese Patent Laid-Open No. 2018-123274 can be mentioned. Examples of the alkali-soluble resin include a polymer (hereinafter, also referred to as "resin (Da)") which has a double bond in a side chain, includes a structural unit ($\alpha$) represented by the following formula (I) and a structural unit ($\beta$) represented by the following formula (II) in a main chain, and further includes an acid group.

The acid group may be introduced into the resin when, for example, the resin (Da) contains a structural unit ($\gamma$) derived from an acid group-containing monomer (for example, (meth)acrylic acid). The resin (Da) preferably contains the structural units ($\alpha$), ($\beta$), and ($\gamma$) in the main chain skeleton.

[Formula 17]

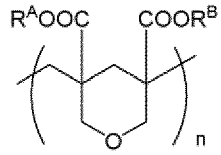

(I)

[In the formula, $R^A$ and $R^B$ are the same or different and each represent a hydrogen atom or a hydrocarbon group having 1 to 25 carbon atoms. n represents the average number of repeating units of the structural units represented by the formula (I), and is a number of 1 or more.]

[Formula 18]

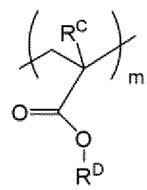

(II)

[In the formula, each $R^C$ is the same or different and represents a hydrogen atom or a methyl group. Each $R^D$ is the same or different and represents a linear or branched chain hydrocarbon group having 4 to 20 carbon atoms, m represents the average number of repeating units of the structural units represented by the formula (II), and is a number of 1 or more.]

The content proportion of the structural unit ($\alpha$) in the resin (Da) is, for example, from the viewpoint of heat resistance and storage stability of the resin (Da), 0.5% by mass or more and 50% by mass or less, preferably 1% by mass or more and 40% by mass or less, and more preferably 5% by mass or more and 30% by mass or less based on 100% by mass of the total amount of all monomer units that give the main chain skeleton of the resin (Da). In the formula (I), n represents the average number of repeating units of the structural units ($\alpha$) in the resin (Da), and n can be set so that the content proportion of the structural units ($\alpha$) falls within the above range.

The content proportion of the structural unit ($\beta$) is, for example, from the viewpoint of the solvent resistance of the cured film, 10% by mass or more and 90% by mass or less, preferably 20% by mass or more and 80% by mass or less, and more preferably 30% by mass or more and 75% by mass or less based on 100% by mass of the total amount of all monomer units that give the main chain skeleton of the resin (Da). In the formula (II), m represents the average number of repeating units of the structural units ($\beta$) in the resin (Da), and m can be set so that the content proportion of the structural units ($\beta$) falls within the above range.

The content proportion of the structural unit ($\gamma$) is, for example, from the viewpoint of the solubility of the resin (Da) in the alkaline substance and the solubility of the resin (Da) in the solvent (G), 0.5% by mass or more and 50% by mass or less, preferably 2% by mass or more and 50% by mass or less, and more preferably 5% by mass or more and 45% by mass or less based on 100% by mass of the total amount of all monomer units that give the main chain skeleton of the resin (Da).

The resin (D) can include one or more selected from the group consisting of the resin [K1], resin [K2], resin [K3], resin [K4] described above and the alkali-soluble resin disclosed in Japanese Patent Laid-Open No. 2018-123274.

Additional examples of the resin (D) include polyalkylene glycol compounds. Examples of the polyalkylene glycol compounds include polyethylene glycol and polypropylene glycol. The polyalkylene glycol compounds are advantageous in increasing the dispersibility of the light scattering agent (A) in the curable composition.

The resin (D) preferably has a weight-average molecular weight (Mw) of 9000 or less in terms of standard polystyrene measured by gel permeation chromatography (GPC). Since the resin (D) has the above Mw, it is possible to improve the development speed of the cured film, and a cured film having a high outgoing light intensity can be obtained.

The Mw of the resin (D) in terms of standard polystyrene is, for example, 1000 or more and 9000 or less, and is preferably 2000 or more and 8500 or less and more preferably 3000 or more and 8500 or less, from the viewpoints of the development speed and outgoing light intensity of the cured film.

The Mw of the resin (D) can be adjusted within the above range by appropriately combining the selection of raw materials to be used, a charging method, and reaction conditions such as reaction temperature and time.

The molecular weight distribution [weight-average molecular weight (Mw) / number-average molecular weight (Mn)] of the resin (D) measured by GPC is, for example, 1.0 or more and 6.0 or less, and preferably 1.2 or more and

4.0 or less from the viewpoint of developability of a cured film.

The acid value of the resin (D) is preferably 90 mg KOH/g or more and 150 mg KOH/g or less based on the solid content. When the acid value is less than 90 mg KOH/g, the solubility of the cured film in an alkali developer may be lowered and a residue may be left on the substrate, and when the acid value is more than 150 mg KOH/g, peeling of a cured pattern obtained by development is more likely to occur.

The acid value of the resin (D) is preferably 95 mg KOH/g or more and 140 mg KOH/g or less, more preferably 100 mg KOH/g or more and 130 mg KOH/g or less, from the viewpoint of the developability of the cured film.

The acid value is a value measured as the amount (mg) of potassium hydroxide necessary for neutralizing 1 g of the resin (D), and can be obtained by titrating with, for example, an aqueous potassium hydroxide solution.

The resin (D) may contain a resin having a double bond equivalent of, for example, 300 g/eq or more and 2000 g/eq or less, preferably 500 g/eq or more and 1500 g/eq or less. Since the resin (D) contains a resin having a double bond equivalent of 300 g/eq or more and 2000 g/eq or less, the phenomenon of being quenched during the step of producing the cured pattern tends to be easily prevented. When the resin (D) contains a resin having a double bond equivalent of less than 300 g/eq, the cured pattern tends to be easily peeled off without being dissolved during development.

Examples of the resin having a double bond equivalent of 300 g/eq or more and 2000 g/eq or less include (meth)acrylic resins. The resin (D) is preferably composed of a (meth)acrylic resin.

In the case where the curable composition contains the resin (D), the content ratio of the resin (D) in the curable composition is, for example, based on the total amount of the solid content of the curable composition, 5% by mass or more, preferably 10% by mass or more, more preferably 15% by mass or more, still more preferably 30% by mass or more, particularly preferably 45% by mass and, for example, 80% by mass or less, preferably 75% by mass or less, and more preferably 65% by mass or less. When the content ratio of the resin (D) is within the above range, the outgoing light intensity tends to be easily maintained at a high level during the step of producing the cured pattern.

In the case where the curable composition contains the resin (D), the mass ratio (solid content ratio) of the resin (D) to the photopolymerizable compound (B) is, for example, 1 or more, and is preferably 1.2 or more and 7.0 or less, more preferably 1.5 or more and 6.0 or less, and still more preferably 2.5 or more and 5.5 or less from the viewpoint of developability of the cured film.

[5] Antioxidant (E)

The curable composition may further contain one or more antioxidants (E).

The antioxidant (E) is not particularly limited as long as it is an antioxidant that is generally used industrially, and a phenol-based antioxidant, a phosphorus-based antioxidant, a phosphorus/phenol composite antioxidant, a sulfur-based antioxidant, and the like can be used.

The phosphorus/phenol composite antioxidant may be a compound having one or more phosphorus atoms and one or more phenol structures in its molecule. From the viewpoint of the developability of the cured film and the outgoing light intensity, the antioxidant (E) preferably contains a phosphorus/phenol composite antioxidant.

Examples of the phenol-based antioxidant include Irganox (R) 1010 (Irganox 1010: pentaerythritol tetrakis[3-(3,5-di-tert-butyl-4-hydroxyphenyl)propionate], manufactured by BASF Japan Ltd.), Irganox 1076 (Irganox 1076: Octadecyl-3-(3,5-di-tert-butyl-4-hydroxyphenyl)propionate, manufactured by BASF Japan Ltd.), Irganox 1330 (Irganox 1330: 3,3',3",5,5',5"-hexa-tert-butyl-a,a',a''-(mesitylene-2,4,6-triyl)tri-p-cresol, BASF Japan Ltd.), Irganox 3114 (Irganox 3114: 1,3,5-tris(3,5-di-tert-butyl-4-hydroxybenzyl)-1,3,5-triazine-2,4,6(1H,3H,5H)-trione, BASF Japan Ltd.), Irganox 3790 (Irganox 3790: 1,3,5-tris((4-tert-butyl-3-hydroxy-2,6-xylyl)methyl)-1,3,5-triazine-2,4,6(1H,3H,5H)-trione, BASF Japan Ltd.), Irganox 1035 (Irganox 1035: thiodiethylenebis[3-(3,5-di-tert-butyl-4 hydroxyphenyl)propionate], manufactured by BASF Japan Ltd.), Irganox 1135 (Irganox 1135: 3,5-bis(1,1-dimethylethyl)-4-hydroxy-C7-C9 side-chain alkyl ester of benzene propanoic acid, manufactured by BASF Japan Ltd.), Irganox 1520 L (Irganox 1520 L: 4,6-bis(octylthiomethyl)-o-cresol, manufactured by BASF Japan Ltd.), Irganox 3125 (Irganox 3125, BASF Japan Ltd.), Irganox 565 (Irganox 565: 2,4-bis(n-octylthio)-6-(4-hydroxy-3',5'-di-tert-butylanilino)-1,3,5-triazine, manufactured by BASF Japan Ltd.), ADK STAB (R) AO-80 (ADK STAB AO-80: 3,9-bis(2-(3-(3-tert-butyl-4-hydroxy-5-methylphenyl)propionyloxy)-1,1-dimethylethyl)-2,4,8,10-tetraoxaspiro(5,5)undecane, manufactured by ADEKA Corporation), SUMILIZER (R) BHT, SUMILIZER GA-80, SUMILIZER GS (manufactured by Sumitomo Chemical Co., Ltd.), Cyanox (R) 1790 (Cyanox 1790, manufactured by Cytec Industries Inc.), and vitamin E (manufactured by Eisai Co., Ltd.).

Examples of the phosphorus-based antioxidant include Irgafos (R) 168 (Irgafos 168: tris(2,4-di-tert-butylphenyl)phosphite, manufactured by BASF Japan Ltd.), Irgafo12 (Irgafos 12: tris[2-[[2,4,8,10-tetra-tert-butyldibenzo[d,f][1,3,2]-dioxaphosphine-6-yl]oxy]ethyl]amine, manufactured by BASF Japan Ltd.), Irgafos 38 (Irgafos 38: bis(2,4-bis(1,1-dimethylethyl)-6-methylphenyl)ethyl ester phosphite, BASF Japan Ltd.), ADK STAB (R) 329K, Irgafos PEP36, Irgafos PEP-8 (all manufactured by ADEKA Corporation), Sandstab P-EPQ (manufactured by Clariant AG), Weston (R) 618, Weston 619G (manufactured by GE), and Ultranox 626 (manufactured by GE).

Examples of the phosphorus/phenol composite antioxidant include SUMILIZER (R) GP (6-[3-(3-tert-butyl-4-hydroxy-5-methylphenyl)propoxy]-2,4,8,10-tetra-tert-butyldibenz[d,f][1.3.2]dioxaphosphepine) (manufactured by Sumitomo Chemical Co., Ltd.).

Examples of the sulfur-based antioxidant include dialkyl thiodipropionate compounds such as dilauryl thiodipropionate, dimyristyl thiodipropionate, and distearate thiodipropionate; and β-alkylmercaptopropionic acid ester compounds of polyols such as tetrakis[methylene(3-dodecylthio)propionate]methane.

In the case where the curable composition contains the antioxidant (E), the content of the antioxidant (E) in the curable composition is, for example, based on 100 parts by mass of the resin (D), 1 part by mass or more, from the viewpoint of easily increasing the heat resistance of the cured film, preferably 2 parts by mass or more, more preferably 3 parts by mass or more, still more preferably 5 parts by mass or more, and particularly preferably 7 parts by mass or more, and, for example, 50 parts by mass or less, from the viewpoint of easily increasing the mechanical strength of the cured film, preferably 40 parts by mass or less, more preferably 30 parts by mass or less, and still more preferably 25 parts by mass or less.

[6] Leveling agent (F)

The curable composition may further contain one or more leveling agents (F). When the leveling agent (F) is contained, the flatness of the cured film can be further improved.

Examples of the leveling agent (F) include a silicone-based surfactant, a fluorine-based surfactant, and a silicone-based surfactant having a fluorine atom. These may have a polymerizable group at its side chain. The leveling agent (F) is preferably a fluorine-based surfactant from the viewpoint of the developability and outgoing light intensity of the cured film.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (manufactured by Dow Corning Toray Co., Ltd.); KP321, KP322, KP323, KP324, KP326, KP340, and KP341 (manufactured by Shin-Etsu Chemical Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (R) FC430 and Fluorad FC431 (manufactured by Sumitomo 3M Limited); MEGAFACE (R) F142D, MEGAFACE F171, MEGAFACE F172, MEGAFACE F173, MEGAFACE F177, MEGAFACE F183, MEGAFACE F554, MEGAFACE F575, MEGAFACE R30, and MEGAFACE RS-718-K (manufactured by DIC Corporation); EFTOP (R) EF301, EFTOP EF303, EFTOP EF351, and EFTOP EF352 (manufactured by Mitsubishi Materials Electronic Chemicals Co., Ltd.); Surflon (R) S381, Surflon S382, Surflon SC101, and Surflon SC105 (manufactured by Asahi Glass Co., Ltd.); and E5844 (manufactured by Daikin Fine Chemical Laboratory).

Examples of the silicone-based surfactant having a fluorine atom include a surfactant having a siloxane bond and a fluorocarbon chain in its molecule. Specific examples thereof include MEGAFACE (R) R08, MEGAFACE BL20, MEGAFACE F475, MEGAFACE F477, and MEGAFACE F443 (manufactured by DIC Corporation).

When the curable composition contains a leveling agent (F), the content ratio of the leveling agent (F) in the curable composition is, for example, based on the total amount of the curable composition, 0.001% by mass or more and 1.0% by mass or less, preferably 0.005% by mass or more and 0.75% by mass or less, more preferably 0.01% by mass or more and 0.5% by mass or less, and still more preferably 0.05% by mass or more and 0.5% by mass or less. When the content ratio of the leveling agent (F) is within the above range, the flatness of the cured film can be further improved.

If necessary, the curable composition may further contain an additive known in the art, such as a photopolymerization initiation aid, a polymerization inhibitor, a filler, other polymeric compound, an adhesion promoter, a light stabilizer, or a chain transfer agent. From the viewpoint of increasing the dispersibility of the light scattering agent (A), the curable composition may contain an organic compound having at least one group selected from the group consisting of a thiol group (-SH), a carboxyl group (-COOH), and an amino group ($-NH_2$).

[7] Solvent (G)

The curable composition may further contain one or more solvents (G). The solvent (G) is not particularly limited as long as it dissolves the photopolymerizable compound (B), and any solvent which has been used conventionally in the art can be used. Examples of the solvent (G) include an ester solvent (a solvent which contains -COO- but does not contain -O- in its molecule), an ether solvent (a solvent which contains -O- but does not contain-COO- in its molecule), an ether ester solvent (a solvent which contains -COO- and-O- in its molecule), a ketone solvent (a solvent which contains -CO- but does not contain -COO- in its molecule), an alcohol solvent (a solvent which contains OH but does not contain

-O-, -CO-nor -COO- in its molecule), an aromatic hydrocarbon solvent, an amide solvent, and dimethyl sulfoxide.

In the case where the curable composition further contains the photopolymerization initiator (C) and/or the resin (D), the solvent (G) preferably dissolves these.

Examples of the ester solvent include methyl lactate, ethyl lactate, n-butyllactate, methyl 2-hydroxy isobutanoate, ethyl acetate, n-butylacetate, isobutylacetate, n-pentyl formate, isopentyl acetate, n-butylpropionate, isopropyl butyrate, ethyl butyrate, n-butylbutyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-butyl methoxyacetate, 3-methyl-3-butyl methoxyacetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin. Examples of the aromatic hydrocarbon solvent include benzene, toluene, xylene, and mesitylene. Examples of the amide solvent include N,N-dimethylformamide, N,N-dimethylacetamide, and N-methylpyrrolidone.

The solvent (G) is preferably propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone, or toluene, or a mixture of two or more of these, and propylene glycol monomethyl ether acetate is more preferably contained.

The solvent (G) is a component other than the solid content of the curable composition, and the solvent contained in the light scattering agent (A), the resin (D), or the like is also included in the solvent (G).

<Method for producing curable composition>

The curable composition can be produced by a method including a step of mixing predetermined components and other components used as necessary. The method for producing the curable composition may further include a step of preparing the resin (D).

A curable composition according to a first embodiment (hereinafter, also referred to as "curable composition M") contains the resin (D). The curable composition M contains the light scattering agent (A), the photopolymerizable compound (B), and the resin (D) and preferably further contains the photopolymerization initiator (C). The curable composition M preferably contains the solvent (G) in order to make the applicability of the composition or the flatness of a composition layer at the time of application good.

The content ratio of the photopolymerizable compound (B) in the curable composition M is, for example, based on the total amount of the solid content of the curable composition, 5% by mass or more and 50% by mass or less, preferably 7% by mass or more and 45% by mass or less, more preferably 10% by mass or more and 40% by mass or less, still more preferably 13% by mass or more and 35% by mass or less, and yet still more preferably 15% by mass or more and 35% by mass or less.

The content ratio of the solvent (G) in the curable composition M is, for example, based on the total amount of the curable composition M, 40% by mass or more and 95% by mass or less, preferably 45% by mass or more and 90% by mass or less, and more preferably 50% by mass or more and 80% by mass or less.

A curable composition according to a second embodiment (hereinafter, also referred to as "curable composition N") does not contain the resin (D). The curable composition N contains the light scattering agent (A) and the photopolymerizable compound (B) and preferably further contains the photopolymerization initiator (C). The curable composition N may contain the solvent (G), but preferably contains no or a small content ratio of the solvent (G).

The content ratio of the photopolymerizable compound (B) in the curable composition N is, for example, based

on the total amount of the solid content of the curable composition, 10% by mass or more and 90% by mass or less, preferably 20% by mass or more and 80% by mass or less, more preferably 30% by mass or more and 75% by mass or less, still more preferably 40% by mass or more and 70% by mass or less, and yet still more preferably 50% by mass or more and 70% by mass or less.

The content ratio of the solvent (G) in the curable composition N is, based on the total amount of the curable composition N, preferably 10% by mass or less, more preferably 5% by mass or less, still more preferably 3% by mass or less, yet still more preferably 2% by mass or less, and particularly preferably 1% by mass or less and may be 0% by mass or 0.5% by mass or more. When the content of the solvent (G) is set to be small, the control of the film thickness at the time of forming the cured film becomes easy, and it is possible to reduce production cost or load on the global environment or operation environment due to the solvent. The curable composition N can be preferably used as ink for an inkjet printer.

<<Method for producing cured film>>

A production method according to the present invention is a method for producing a cured film of a curable composition, and the curable composition contains at least the light scattering agent (A) and the photopolymerizable compound (B).

The production method according to the present invention is preferable as a method for producing a cured film having a high Martens hardness and is preferable as a method for producing a cured film of a curable composition containing the light scattering agent (A) and the photopolymerizable compound (B) and having a Martens hardness of 0.10 GPa or more. Regarding a preferable range of the Martens hardness of a cured film obtained by the production method according to the present invention, the description in the <<cured film>> is referred to.

The production method according to the present invention includes the following steps.

An exposure step of irradiating a film of the curable composition containing the light scattering agent (A) and the photopolymerizable compound (B) (hereinafter, also referred to as "composition layer") with light, and
a thermal curing step of thermally curing the composition layer.

It is preferable to perform the exposure step and then the thermal curing step.

The method for producing a cured film may include other steps other than the above-described steps. Examples of the other steps include an application step of applying the curable composition to a substrate, an ejection step of ejecting the curable composition into a region divided with a bank on a substrate on which the bank is formed, a drying step of drying the composition layer formed by the application step or the ejection step, a development step that is carried out on the composition layer after the exposure step, and the like. The cured film may be formed on the entire surface of the substrate or may be formed on a part of the surface of the substrate as a cured pattern.

The curable composition that is used to form the cured film contains the light scattering agent (A) and the photopolymerizable compound (B), and an example thereof is the curable composition described in the

<curable composition>.

The application step is a step of applying the curable composition to the substrate to form the composition layer. Examples of the coating method include a spin coating method, a slit coating method, and a slit and spin coating method. The ejection step may be a step of selectively ejecting or attaching the curable composition to the region divided with the bank by, for example, an inkjet method.

Examples of the substrate include a glass plate made from, for example, quartz glass, borosilicate glass, alumina silicate glass, soda lime glass of which the surface is coated with silica, or the like; a resin plate made from, for example, polycarbonate, polymethyl methacrylate, polyethylene terephthalate or the like; a substrate made from silicon; and a substrate produced by forming a thin film made from aluminum, silver or a silver/copper/palladium alloy or the like on a substrate. The substrate is preferably a glass plate, a silicon substrate, or the like.

The substrate may have been subjected to a pretreatment by which the wettability of the surface of the substrate can be adjusted. Examples of the pretreatment include washing with a solvent such as an alcohol or acetone, an acid treatment, an alkali treatment, a plasma treatment, a corona treatment, and the like. The coatability of the curable composition can be improved more than on an untreated substrate by selecting an appropriate pretreatment for a substrate on which the cured film is to be laminated.

In the case where the curable composition contains the solvent (G), it is preferable to perform the drying step of removing a volatile component such as the solvent (G) from the composition layer after the application step. The drying step may include a heating and drying (prebaking) treatment, may include a drying under reduced pressure treatment, or may include both.

The temperature to be employed in the case where heat-drying is carried out is preferably 30°C or more and 120°C or less, more preferably 50°C or more and 110°C. The heating time is preferably 10 seconds or more and 60

minutes or less, and more preferably 30 seconds or more and 30 minutes or less.

In the case where drying under reduced pressure is carried out, it is preferred to carry out the drying procedure under a pressure of 50 Pa or more and 150 Pa or less and at a temperature of 20°C or more and 25°C or less.

The film thickness of the composition layer after the application step, after the ejection step, or after the drying step is not particularly limited, and may be selected appropriately depending on the desired film thickness of the cured film to be produced, and is, for example, 1 μm or more and 20 μm or less, preferably 1.5 μm or more and 18 μm or less, more preferably 2 μm or more and 14 μm or less, and still more preferably 2 μm or more and 12 μm or less. The film thickness of the cured film that is obtained in the end may also be the same as described above.

Next, the exposure step is carried out on the composition layer after the application step, after the ejection step, or after the drying step. The exposed composition layer is cured by polymerizing the photopolymerizable compound (B) and the like contained in the composition layer. The light sources used for exposure are preferably a light source that emits light having a wavelength of 250 nm or more to 450 nm or less. In the case where the curable composition contains the photopolymerization initiator (C), light in the vicinity of 436 nm, 408 nm, or 365 nm may be selectively extracted from the light having the wavelength according to the absorption wavelength of the photopolymerization initiator (C) by a band-pass filter. Specific examples of the light source include a mercury lamp, a light-emitting diode, a metal halide lamp, and a halogen lamp.

The light exposure X in the exposure step is, from the viewpoint of increasing the Martens hardness of the obtained cured film, preferably 50 $mJ/cm^2$ or more, more preferably 80 $mJ/cm^2$ or more, still more preferably 100 $mJ/cm^2$ or more, and yet still more preferably 150 $mJ/cm^2$ or more. The light exposure X is usually 1000 $mJ/cm^2$ or less, preferably 800 $mJ/cm^2$ or less, and more preferably 700 $mJ/cm^2$ or less. When the light exposure X in the exposure step is 1000 $mJ/cm^2$ or less, excessive shrinkage of the cured film can be prevented, and thus it is possible to prevent the light scattering agent (A) in the film from agglomerating or coming close to each other due to the shrinkage of the cured film and to prevent a decrease in the outgoing light intensity.

The light exposure X is a light exposure at a wavelength of 365 nm as a basis and can be measured using an accumulated UV meter (UIT-250, manufactured by Ushio Inc.).

One example of a method for forming the cured pattern, which is one embodiment of the cured film, is a photolithography method. The photolithography method is a method in which the composition layer is exposed to light through a photomask for forming a desired cured pattern and developed. In this case, a light-exposing device such as a mask aligner and a stepper is preferably used because the device is capable of emitting a parallel light beam uniformly over the whole area of the exposed surface or aligning the photomask accurately to the substrate which has the composition layer formed thereon.

The composition layer is subjected to the development step of bringing the composition layer after the exposure step into contact with a developer, whereby the unexposed portion of the composition layer is dissolved and removed in the developer to impart a pattern to the composition layer. Examples of the developer include an aqueous solution of an alkaline compound such as potassium hydroxide, sodium hydrogen carbonate, sodium carbonate and tetramethylammonium hydroxide; and organic solvents. The concentration of the alkaline compound in the aqueous solution is preferably 0.01% by mass or more and 10% by mass or less, and more preferably 0.03% by mass or more and 5% by mass or less. Examples of the organic solvent include the same as the solvent (G). The developer may contain a surfactant.

The developing method may be any of a paddle method, a dipping method, a spray method and the like. Further, the substrate may be inclined at any degree during development.

The composition layer after the exposure step or after the development step is thermally cured (post-baked) in the thermal curing step. Polymerization of the photopolymerizable compound (B) and the like can be further advanced by the thermal curing step.

The thermal curing temperature Y in the thermal curing step is, from the viewpoint of increasing the Martens hardness of the obtained cured film, preferably 80°C or higher, more preferably 90°C or higher, still more preferably 100°C or higher, yet still more preferably 120°C or higher, and particularly preferably 150°C or higher. The thermal curing temperature Y is usually 250°C or lower, preferably 240°C or lower, and more preferably 235°C or lower. When the thermal curing temperature Y in the thermal curing step is 250°C or lower, excessive shrinkage of the cured film can be prevented, and thus it is possible to prevent the light scattering agent (A) in the film from agglomerating or coming close to each other due to the shrinkage of the cured film and to prevent a decrease in the outgoing light intensity.

The thermal curing time Z in the thermal curing step is, from the viewpoint of increasing the Martens hardness of the obtained cured film, preferably 0.1 hr or longer, more preferably 0.2 hr or longer, still more preferably 0.4 hr or longer, and yet still more preferably 0.5 hr or longer. The thermal curing time Z is usually 2 hr or shorter, preferably 1.5 hr or shorter, and more preferably 1.2 hr or shorter.

The thermal curing step can be carried out under an air atmosphere or can be carried out under a vacuum atmosphere. From the viewpoint of increasing the Martens hardness of the obtained cured film and from the viewpoint of increasing the outgoing light intensity of the cured film, the thermal curing step is preferably carried out under a vacuum atmosphere. The vacuum atmosphere refers to a pressure range of 150 Pa or less, preferably 120 Pa or less, more

preferably 100 Pa or less and may be 50 Pa or more.

Another example of the method for forming the cured pattern, which is one embodiment of the cured film, is an inkjet method, a printing method, or the like. An example of the method for forming the cured pattern by the inkjet method is a method in which a bank is formed on a substrate, then, the curable composition is selectively attached to a region divided by the bank on the substrate by the inkjet method, and the curable composition is cured by exposure in the exposure step and/or thermal curing in the thermal curing step. Examples of a method for forming the bank include a photolithography method, an inkjet method, and the like, and the bank is preferably formed by the inkjet method.

The light exposure X (mJ/cm$^2$) in the exposure step, the thermal curing temperature Y (°C) in the thermal curing step, and the thermal curing time Z (hr) satisfy the following formula (1):

$$X \times Y \times Z^2 \geq 3000 \quad (1).$$

By carrying out the exposure step and the thermal curing step such that the formula (1) is satisfied, a cured film having a high Martens hardness can be produced, and it becomes possible to produce a cured film having a Martens hardness of 0.10 GPa or more. Hereinafter, $X \times Y \times Z^2$ will also be referred to as the P value.

From the viewpoint of producing a cured film having a high Martens hardness, the P value is preferably 4000 or more, more preferably 5000 or more, still more preferably 6000 or more, yet still more preferably 7000 or more, and particularly preferably 8000 or more. The P value is also preferably 10000 or more and, furthermore, 15000 or more, 18000 or more, or 20000 or more. From the viewpoint of suppressing a decrease in the outgoing light intensity of the cured film, the P value is preferably 150000 or less, more preferably 140000 or less, and still more preferably 120000 or less and may be 100000 or less, 30000 or less, 22000 or less, or 20000 or less. In addition, when the P value is within the above range, the dispersibility of the light scattering agent (A) in the cured film increases, which makes it easy to obtain a cured film having a small variation in outgoing light intensity.

<<Display device >>

A display device according to the present invention includes at least a light source and the cured film. Examples of the display device include a liquid crystal display device, an organic EL display device, or an inorganic EL display device, and specific examples thereof include display devices disclosed in Japanese Patent Laid-Open No. 2006-309219, Japanese Patent Laid-Open No. 2006-310303, Japanese Patent Laid-Open No. 2013-15812, Japanese Patent Laid-Open No. 2009-251129, and Japanese Patent Laid-Open No. 2014-2363.

The cured film according to the present invention in the display device is used as the white (transparent, achromatic) pattern and usually constitutes pixels in combination with a chromatic pattern. This chromatic pattern has a function of converting the wavelength of incident light and causing the light to outgo and may be a cured pattern of a curable composition containing a colorant (quantum dots, a pigment, a dye, or the like).

A display device according to one embodiment of the present invention includes a backlight that is a blue light source and a plurality of patterns provided on the viewing side of the backlight, the patterns include a red pattern, a green pattern, and the white (transparent, achromatic) pattern, which is the cured film according to the present invention, and light having a wavelength that is emitted from the blue light source is discharged from the white pattern.

Examples

Hereinafter, the present invention will be described in more detail by way of examples. Unless otherwise specified, "%" and "part" in the example are % by mass and parts by mass.

[Measurement of Martens hardness of cured film]

A Berkovich pyramid indenter was mounted in a microhardness tester (manufactured by Elionix Inc., ENT-2100), a load/unload test was carried out on a cured film formed on a substrate, and a load/indentation curve was measured. The measurement temperature was set to room temperature. Here, the maximum test load was set to 6 mN, no holding time was given, and the load was removed to be 0 mN. Measurement data was processed with ENT-Win ver. 7.50 (manufactured by Elionix Inc.), and the indentation hardness and the Martens hardness (GPa) were obtained.

[Measurement of optical density of cured film]

A narrow directional angle type sensing backlight illumination (OPF series; manufactured by OPTEX FA CO., LTD.) equipped with an LED lamp having an emission wavelength of 444 nm and a scratch resistant cover was prepared

as a backlight. A backlight was placed with the scratch resistant cover facing upward, and an optical fiber for detecting light emission connected to the following spectrometer was installed at a position 4 cm high from the surface of the scratch resistant cover. A glass substrate (Eagle 2000; manufactured by Corning Incorporated) as a reference was placed on the surface of the scratch resistant cover of the backlight. In this state, the backlight was turned on, the outgoing light intensity (unit: μW) of light that had passed through the reference in a range of wavelengths of 400 nm or more and 500 nm or less was measured, and the maximum value was indicated by I0. The outgoing light intensity was measured using a spectrum analyzer (Spectrum meter, manufactured by Ocean Optics, Inc.).

Next, the substrate having the cured film was disposed on the surface of the reference glass substrate. In this state, the backlight was turned on, the outgoing light intensity (unit: μW) of light emitted from the cured film in a range of wavelengths of 400 nm or more and 500 nm or less was measured, and the maximum value was indicated by I.

The optical density (OD value) was obtained based on the measurement results according to the following formula.

$$\text{OD value} = -\text{Log}(I/I0)$$

In addition, a value (OD value/T) was obtained by dividing the OD value by the film thickness T (μm) of the cured film. The film thickness T of the cured film was measured using a film thickness measuring device ("DEKTAK XT" manufactured by Bluker).

[Measurement of pencil hardness of cured film]

The pencil hardness of the surface of the cured film formed on the substrate was measured using a TriboGear both-way wear tester (Type: 30, manufactured by Shinto Scientific Co., Ltd.) according to a pencil hardness test regulated in JIS K 5600-5-4:1999 "Testing methods for paints-Part 5 : Mechanical property of film- Section 4 : Scratch hardness (Pencil method)". The load in the measurement was set to 500 g, and the speed was set to 40 mm/sec.

[Weight-average molecular amount]

The weight-average molecular weight (Mw) of the resin (D1) was measured by the GPC method under the following conditions.

Equipment: K2479 (manufactured by Shimadzu Corporation)
Column: SHIMADZU Shim-pack GPC-80M
Column temperature: 40°C
Solvent: tetrahydrofuran
Flow rate: 1.0 mL/min
Detector: RI
Standard for calibration; TSK STANDARD POLYSTYRENE F-40, F-4, F-288, A-2500, A-500 (manufactured by Tosoh Corporation)

[Acid value]

3 g of the resin (D1) solution was finely weighed, dissolved in a mixed solvent of 90 g of acetone and 10 g of water, and the acid value of the resin (D1) solution was measured by an automatic titrator (manufactured by HIRANUMA Co., Ltd., trade name: COM-555) using the KOH aqueous solution specified in 0.1 as the titrant, and the acid value (AV) per 1 g of solid content was determined from the acid value of the solution and the solid content of the solution.

[Solid content]

About 1 g of the resin (D1) solution was weighed in an aluminum cup, dried at 180°C for 1 hour, and then the mass was measured. The solid content (% by mass) of the resin (D1) solution was calculated from the mass reduction amount.

(Production Example 1: Preparation of dispersion of light scattering agent (A1))

DISPERBYK21116 (manufactured by BYK Japan KK) was added to 70 parts of $TiO_2$ nanoparticles in a solid content of 3 parts and propylene glycol monomethyl ether acetate (hereinafter referred to as "PGMEA") in a total amount

of 100 parts, and the mixture was stirred with a paint shaker until it was sufficiently dispersed to obtain a dispersion (solid content: 73%) of a scattering agent (A1).

(Production Example 2: Preparation of resin (D1) solution)

After 110 parts of PGMEA was put into a flask equipped with a stirrer, a reflux cooling tube with a thermometer, a dropping funnel, and a nitrogen introduction tube, the mixture was stirred while purging nitrogen, and the temperature was raised to 80°C. A solution obtained by dissolving 25 parts of dicyclopentanyl methacrylate, 26 parts of methyl methacrylate, 16 parts of methacrylic acid, and 11 parts of 2,2'-azobis(2,4-dimethylvaleronitrile) in 110 parts of PGMEA was dropped from a dropping funnel into a flask, and stirred at 80°C for 3 hours.

Next, 16 parts of glycidyl methacrylate, 0.4 parts of 2,2'-methylenebis(4-methyl-6 tert-butylphenol), and 0.8 parts of triphenylphosphine were put into a flask, and the temperature was raised to 110°C and stirred for 8 hours to react the carboxylic acid in the polymer with the epoxy group to introduce a polymerizable unsaturated bond. Then, 17 parts of 1,2,3,6-tetrahydrophthalic acid anhydride was added and the reaction was continued for 3 hours to introduce carboxylic acid groups into the side chains. The reaction solution was cooled to room temperature to obtain a resin (D1) solution.

The resin (D1) had a weight-average molecular weight in terms of standard polystyrene of 7600, a molecular weight distribution of 2.1, and an acid value of 100 mg KOH/g, and the solid content in the resin (D1) solution was 40% by mass.

(Production Examples 3 to 6: Preparation of curable compositions 1 to 4)

Curable compositions 1 to 4 were prepared by mixing the dispersion of the light scattering agent (A1) obtained in Production Example 1, the resin (D1) solution obtained in Production Example 2, and other components shown in Table 1 in a predetermined amount.

(Production Example 7: Preparation of curable composition 5)

A curable composition 5 was prepared by mixing the dispersion of the light scattering agent (A1) obtained in Production Example 1 and other components shown in Table 1 in a predetermined amount.

The composition of the obtained curable composition is shown in Table 1. In Table 1, the contents of components other than the solvent (G) are in terms of solid content (unit: parts by mass). The unit of the content of the solvent (G) is parts by mass. The solvent (G) in Table 1 contains a solvent contained in the dispersion or solution used for preparing the curable composition.

[Table 1]

| Production example | | 3 | 4 | 5 | 6 | 7 |
|---|---|---|---|---|---|---|
| Curable composition No | | 1 | 2 | 3 | 4 | 5 |
| Light scattering agent (A) | (A1) | 5.0 | 5.0 | 5.0 | 10.0 | 6.0 |
| Photopolymerizable compound (B) | (B1) | 10.1 | 11.2 | 5.7 | 13.2 | 20.3 |
| | (B2) | 14.3 | 14.9 | 8.6 | 18.4 | |
| | (B3) | | | | | 20.1 |
| | (B4) | | | | | 27.2 |
| Photopolymerization initiator (C) | (C1) | 1.9 | 1.9 | 1.9 | 1.9 | 3.9 |
| Resin (D) | (D1) | 64.5 | 62.8 | 74.6 | 52.3 | |
| Antioxidant (E) | (E1) | 3.5 | 3.5 | 3.5 | 3.5 | 19.4 |
| Leveling agent (F) | (F1) | 0.1 | 0.1 | 0.1 | 0.1 | 0.1 |
| Additive (X) | (X1) | 0.6 | 0.6 | 0.6 | 0.6 | |
| Total of above | | 100.0 | 100.0 | 100.0 | 100.0 | 97.0 |
| Solvent (G) | (G1) | 100.0 | 100.0 | 100.0 | 100.0 | 3.0 |
| | (G2) | 86.0 | 86.0 | 86.0 | 86.0 | |

The details of the abbreviations of the components shown in Table 1 are as follows.

[1] Photopolymerizable compound (B1): M-510 (carboxy group-containing polyfunctional (meth)acrylate, trade name "ARONIX M-510" manufactured by Toagosei Co., Ltd., solid content: 100%). This compound corresponds to the photopolymerizable compound (B-3a).
[2] Photopolymerizable compound (B2): A-9550 (dipentaerythritol polyacrylate, manufactured by SHIN-NAKAMURA CHEMICAL Co., Ltd., solid content: 100%). This compound corresponds to the photopolymerizable compound (B-3b).
[3] Photopolymerizable compound (B3): VEEA (registered trademark) (2-(2-vinyloxyethoxy)ethyl acrylate, manufactured by Nippon Shokubai Co., Ltd.). This compound corresponds to the photopolymerizable compound (B-4) .
[4] Photopolymerizable compound (B4): LIGHT ESTER E (ethyl methacrylate, manufactured by Kyoeisha Chemical Co., Ltd.). This compound corresponds to the photopolymerizable compound (B-1).
[5] Photopolymerization initiator (C1): compound represented by the following formula. Production was performed by the method disclosed in Japanese Patent Laid-Open No. 2011-132215 (solid content: 100%).

[Formula 19]

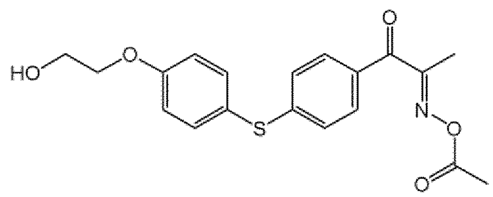

[6] Antioxidant (E1): SUMILIZER -GP (phosphorus/phenol composite antioxidant, manufactured by Sumitomo Chemical Co., Ltd., solid content: 100%)
[7] Leveling agent (F1): F-554 (fluorine-based leveling agent, manufactured by DIC Corporation, solid content: 100%)
[8] Additive (X1): 3-mercaptopropionic acid (manufactured by Tokyo Chemical Industry Co., Ltd., solid content: 100%)
[9] Solvent (G1): PGMEA (propylene glycol monomethyl ether acetate)
[10] Solvent (G2): cyclohexyl acetate

<Example 1>

Onto a 5-cm square glass substrate (Eagle 2000; manufactured by Corning Incorporated), the curable composition 1 obtained in Production Example 3 was applied by a spin coat method so that the film thickness became about 10 μm, and then a drying step (prebaking) was carried out at 100°C for 3 minutes, to form a film of the curable composition 1. On this film, an exposure step was carried out by light irradiation in a light exposure (basis: 365 nm) of 100 $mJ/cm^2$ under an air atmosphere using an exposure device (TME-150RSK; manufactured by TOPCON CORPORATION), after development, a thermal curing step was carried out by carrying out a thermal curing treatment (post baking) under an air atmosphere at 80°C for one hour, thereby obtaining a substrate having a cured film.

<Examples 2 to 5 and Comparative Example 1>

Substrates having a cured film were obtained by carrying out the drying step, the exposure step and the thermal curing step in the same manner as in Example 1 except that the light exposure X ($mJ/cm^2$) in the exposure step, the thermal curing temperature Y (°C), the thermal curing time Z (hr), and the thermal curing atmosphere in the thermal curing step were set as shown in Table 2. "Vacuum" in the thermal curing atmosphere in Table 2 means a pressure of 100 kPa.

The P values, the measurement results of the Martens hardness, the measurement results of the pencil hardness, the film thicknesses, the OD values, and the measurement results of the OD value/T are shown in Table 2.

[Table 2]

| | | Example | | | | | Comparative Example |
|---|---|---|---|---|---|---|---|
| | | 1 | 2 | 3 | 4 | 5 | 1 |
| Curable composition No. | | 1 | 1 | 1 | 1 | 1 | 1 |
| Drying step | Drying conditions | 100°C/3 minutes | 100°C/3 minutes | 100°C/3 minutes | 100°C/3 minutes | 100°C/3 minutes | 100°C/3 minutes |
| Exposure step | Light exposure ($mJ/cm^2$) | 100 | 100 | 100 | 100 | 500 | 100 |
| Thermal curing step | Thermal curing temperature (°C) | 80 | 180 | 180 | 230 | 230 | 25 |
| | Thermal curing time (hr) | 1 | 1 | 1 | 1 | 1 | 1 |
| | Thermal curing atmosphere | Atmosphere | Atmosphere | Vacuum | Atmosphere | Atmosphere | Atmosphere |
| P value | | 8000 | 18000 | 18000 | 23000 | 115000 | 2500 |
| Martens hardness (GPa) | | 0.16 | 0.22 | 0.25 | 0.26 | 0.28 | 0.06 |
| Pencil hardness | | 8 | 2H | 8H | 4H | 4H | 2B |
| OD value | | 0.15 | 0.15 | 0.13 | 0.16 | 0.17 | 0.16 |
| Film thickness (μm) | | 10.30 | 9.82 | 9.28 | 8.93 | 9.23 | 11.00 |
| OD value/T | | 0.0146 | 0.0153 | 0.0140 | 0.0179 | 0.0184 | 0.0145 |

<Examples 6 to 9>

Substrates having a cured film were obtained by carrying out the drying step, the exposure step and the thermal curing step in the same manner as in Example 1 except that the curable compositions shown in Table 3 were used, and the light exposure X (mJ/cm$^2$) in the exposure step, the thermal curing temperature Y (°C), the thermal curing time Z (hr), and the thermal curing atmosphere in the thermal curing step were set as shown in Table 3.

The P values, the measurement results of the Martens hardness, the measurement results of the pencil hardness, the film thicknesses, the OD values, and the measurement results of the OD value/T are shown in Table 3.

[Table 3]

| | | Example | | | |
|---|---|---|---|---|---|
| | | 6 | 7 | 8 | 9 |
| Curable composition No | | 2 | 3 | 4 | 5 |
| Drying step | Drying conditions | 100°C/3 minutes | 100°C/3 minutes | 100°C/3 minutes | 25°C/10 minutes |
| Exposure step | Light exposure (mJ/cm$^2$) | 100 | 100 | 100 | 100 |
| Thermal curing step | Thermal curing temperature (°C) | 180 | 180 | 180 | 180 |
| | Thermal curing time (hr) | 1 | 1 | 1 | 1 |
| | Thermal curing atmosphere | Atmosphere | Atmosphere | Atmosphere | Atmosphere |
| P value | | 18000 | 18000 | 18000 | 18000 |
| Martens hardness (GPa) | | 0.22 | 0.21 | 0.24 | 0.22 |
| Pencil hardness | | 2H | 2H | 2H | 2H |
| OD value | | 0.15 | 0.18 | 0.35 | 0.19 |
| Film thickness (μm) | | 10.16 | 10.62 | 10.33 | 10.43 |
| OD value/T | | 0.0148 | 0.0169 | 0.0339 | 0.0182 |

**Claims**

**1.** A cured film of a curable composition, the curable composition comprising a light scattering agent (A) and a photopolymerizable compound (B),
wherein the cured film has a Martens hardness of 0.10 GPa or more.

**2.** The cured film according to claim 1, wherein the curable composition further comprises a photopolymerization initiator (C).

**3.** The cured film according to claim 1 or 2, wherein the curable composition further comprises a resin (D).

**4.** The cured film according to any one of claims 1 to 3, wherein the light scattering agent (A) contains $TiO_2$ particles.

**5.** A method for producing a cured film of a curable composition comprising a light scattering agent (A) and a photopolymerizable compound (B), the method comprising:

an exposure step of irradiating a film of the curable composition with light; and
a thermal curing step of thermally curing the film of the curable composition,
wherein, when a light exposure in the exposure step is indicated by X (mJ/cm$^2$), a thermal curing temperature in the thermal curing step is indicated by Y (°C), and a thermal curing time is indicated by Z (hr), the following

formula (1):

$$X \times Y \times Z^2 \geq 3000 \quad (1)$$

is satisfied.

6. The production method according to claim 5, wherein the thermal curing step is carried out under a vacuum atmosphere.

7. A display device comprising the cured film according to any one of claims 1 to 4.

## INTERNATIONAL SEARCH REPORT

International application No. **PCT/JP2022/007016**

**A. CLASSIFICATION OF SUBJECT MATTER**

***C08F 2/44***(2006.01)i; ***C08F 2/50***(2006.01)i; ***G03F 7/004***(2006.01)i; ***G03F 7/027***(2006.01)i
FI: C08F2/44 A; C08F2/50; G03F7/004 505; G03F7/027

According to International Patent Classification (IPC) or to both national classification and IPC

**B. FIELDS SEARCHED**

Minimum documentation searched (classification system followed by classification symbols)

C08F2/44; C08F2/50; G03F7/004; G03F7/027

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2019-109515 A (SAMSUNG ELECTRONICS CO LTD) 04 July 2019 (2019-07-04) claims, paragraphs [0085], [0165]-[0167] | 1-5, 7<br>6 |
| X<br>Y | JP 2019-123866 A (SAMSUNG ELECTRONICS CO LTD) 25 July 2019 (2019-07-25) claims, paragraphs [0242]-[0258] | 1-5, 7<br>6 |
| X<br>Y<br>A | JP 2005-248060 A (TOYO INK MFG CO LTD) 15 September 2005 (2005-09-15) claims, paragraphs [0003], [0006], [0076]-[0088] | 1-3, 5, 7<br>6<br>4 |
| Y | JP 2017-88876 A (MITSUBISHI CHEM CORP) 25 May 2017 (2017-05-25) claims, paragraphs [0017], [0090]-[0092] | 6 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 April 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2022/007016**

**C. DOCUMENTS CONSIDERED TO BE RELEVANT**

| Category* | Citation of document, with indication, where appropriate, of the relevant passages | Relevant to claim No. |
|---|---|---|
| P, X | WO 2021/215254 A1 (DAINIPPON INK & CHEMICALS) 28 October 2021 (2021-10-28) claims, paragraphs [0142]-[0144], [0181]-[0209] | 1-5, 7 |
| P, A | | 6 |

Form PCT/ISA/210 (second sheet) (January 2015)

**INTERNATIONAL SEARCH REPORT**
**Information on patent family members**

International application No.
**PCT/JP2022/007016**

| Patent document cited in search report | Publication date (day/month/year) | Patent family member(s) | Publication date (day/month/year) |
|---|---|---|---|
| JP 2019-109515 A | 04 July 2019 | US 2019/0185743 A1<br>claims, paragraphs [0174], [0292]-[0296]<br>US 2021/0324263 A1<br>EP 3498803 A1<br>KR 10-2019-0073301 A<br>CN 110018591 A | |
| JP 2019-123866 A | 25 July 2019 | US 2019/0211260 A1<br>claims, paragraphs [0369]-[0385]<br>EP 3511394 A1<br>CN 110028948 A<br>KR 10-2019-0085885 A | |
| JP 2005-248060 A | 15 September 2005 | (Family: none) | |
| JP 2017-88876 A | 25 May 2017 | (Family: none) | |
| WO 2021/215254 A1 | 28 October 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014157296 A
- JP 2011132215 A
- JP 2000080068 A
- JP 2011178776 A
- WO 2017051680 A
- WO 2020004601 A
- WO 200878678 A
- WO 200878686 A
- WO 2012132558 A
- JP 6075372 A
- JP 6075373 A
- JP 48038403 A
- JP 62174204 A
- JP 7010913 A
- JP 2018123274 A
- JP 2006309219 A
- JP 2006310303 A
- JP 2013015812 A
- JP 2009251129 A
- JP 2014002363 A


### Non-patent literature cited in the description


- Experimental Method for Polymer Synthesis. Kagaku-Dojin Publishing Company, INC, 01 March 1972